(19) Europäisches Patentamt
European Patent Office
Office européen des brevets

(11) **EP 1 677 220 A2**

(12) **EUROPEAN PATENT APPLICATION**

(43) Date of publication:
05.07.2006 Bulletin 2006/27

(51) Int Cl.:
*G06F 17/50* (2006.01)

(21) Application number: 05006822.0

(22) Date of filing: 29.03.2005

(84) Designated Contracting States:
**AT BE BG CH CY CZ DE DK EE ES FI FR GB GR HU IE IS IT LI LT LU MC NL PL PT RO SE SI SK TR**
Designated Extension States:
**AL BA HR LV MK YU**

(30) Priority: **28.12.2004 JP 2004380973**

(71) Applicant: FUJITSU LIMITED
Kawasaki-shi,
Kanagawa 211-8588 (JP)

(72) Inventor: **Imai, Kanako**
**c/o Fujitsu Limited**
**Kawasaki-shi**
**Kanagawa 211-8588 (JP)**

(74) Representative: **HOFFMANN EITLE**
**Patent- und Rechtsanwälte**
**Arabellastrasse 4**
**81925 München (DE)**

(54) **Numerical analysis aiding device, method, program and computer readable recording medium having the program recorded thereon**

(57) The present invention is an appellation, wherein design time can be reduced and necessary data can be readily and quickly obtained by checking the boundary condition in an analysis model before performing the analysis by the solver, by including:

a space determination unit (11) for determining, with regard to a master surface to be verified among the two surfaces forming the pair, whether or not given slave nodes composing a slave surface are included in a check space formed by projecting the master surface to its normal direction; and
an interference determination unit (12) for calculating the distance between the master surface and the slave surface if the slave nodes are determined to exist in the check space according to the determination of the space determination unit (11), and determining that interference is occurring if the distance is smaller than zero.

FIG. 1

**Description**

BACKGROUND OF THE INVENTION

(1) Field of the Invention

The present invention relates to a technique for checking a boundary condition between surfaces forming a pair associated with each element in an analysis model used, for example, in Finite Element Method or Boundary Element Method, for two of the elements having a boundary condition defined between two surfaces.

(2) Description of Related Art

In recent years, numerical simulation (numerical analysis) is commonly performed using, for example, Finite Element Method to guarantee reliability and optimize configuration at an early designing stage in development of various products.

In such a numerical simulation, a preprocessor generates an analysis model by partitioning (mesh-creating) the modeling data generated by, for example, a three dimensional CAD (Computer Aided Design) system into minute polyhedral elements such as minute hexahedrons, pentahedrons or tetrahedrons. Subsequently, a solver performs various types of analysis and the result is displayed by a postprocessor.

In such a numerical simulation, it is known that an analysis model must be generated correctly and the analysis model will be inspected using procedures such as shown in the following patent literature 1, for example.

Additionally, in a numerical simulation, boundary conditions (e.g., contact definition) between surfaces of the elements composing the analysis model must be configured correctly. In prior arts, it is known to perform contact determination using a method shown in the following patent literature 2, for example.

[Patent Literature 1] Japanese Patent Application Laid-Open No.HEI5-108768
[Patent Literature 2] Japanese Patent Application Laid-Open No.HEI6-325136

However, as for boundary condition check (contact check) between surfaces of the elements composing the analysis model in such a conventional procedure, the correctness of the boundary condition is checked after the analysis is executed by the solver, with reference to its output files or results, which takes a long time before a mistake is noticed in the boundary condition setting, thereby preventing reduction of design time.

Additionally, in prior arts, since individual tools of the preprocessor, the solver, the postprocessor and the like manage their necessary data separately, the operator is required to manually take out desired information from a plurality of tools or locations, which leads to the problem of wasted time in looking around many locations to obtain the desired data. In the case of the analysis input data file, for example, it is necessary to search the material number of the element definition from the material definition part after having confirmed the material number of the element definition of the analysis input data file in order to confirm the material property value of an element, that is, the element definition part and the material definition part must be confirmed separately.

SUMMARY OF THE INVENTION

The present invention is directed to address the above problems, so that design time can be reduced and necessary data can be readily and quickly obtained by checking the boundary condition in an analysis model before performing the analysis by the solver.

For the above purpose, a numerical analysis aiding device of the present invention is characterized in being a numerical analysis aiding device for verifying a boundary condition between surfaces forming a pair associated with each element in an analysis model comprising a component which is element-partitioned into two or more elements, for two of said elements having a boundary condition defined between two surfaces, said device comprising:

a space determination unit for determining, with regard to a master surface to be verified among said two surfaces forming the pair, whether or not given slave nodes composing a slave surface other than said master surface among said two surfaces forming the pair are included in a check space formed by projecting said master surface to its normal direction; and

an interference determination unit for calculating the distance between said master surface and said slave surface if said slave nodes are determined to exist in the check space according to the determination of said space determination unit, and determining that interference is occurring if said distance is smaller than zero.

Additionally, the numerical analysis aiding device of the present invention is characterized in being a numerical analysis aiding device for verifying a boundary condition between surfaces forming a pair associated with each element in an analysis model comprising a component which is element-partitioned into two or more elements, for two of said elements having a boundary condition defined between two surfaces, said device comprising:

a normal angle calculation unit for calculating a normal angle formed by the normal of a master surface to be verified among said two surfaces forming the pair and the normal of a slave surface other than said master surface among said two surfaces forming the pair, based on the normal directions of said master surface and said slave surface, respectively.

Furthermore, the numerical analysis aiding device of the present invention is characterized in being a numerical analysis aiding device for verifying a boundary condition between surfaces forming a pair associated with each element in an analysis model comprising a component which is element-partitioned into two or more elements, for two of said elements having a boundary condition defined between two surfaces, said device comprising:

a space determination unit for determining, with regard to a master surface to be verified among said two surfaces forming the pair, whether or not given slave nodes composing a slave surface other than said master surface among said two surfaces forming the pair are included in a check space formed by projecting said master surface to its normal direction;

an interference determination unit for calculating the distance between said master surface and said slave surface if said slave nodes are determined to exist in the check space according to the determination of said space determination unit, and determining that interference is occurring if said distance is smaller than zero; and

a normal angle calculation unit for calculating a normal angle formed by the normal of said master surface and the normal of said slave surface, based on the normal directions of said master surface and said slave surface, respectively.

Additionally, the numerical analysis aiding device of the present invention is characterized in being a numerical analysis aiding device for verifying a boundary condition between surfaces forming a pair associated with each element in an analysis model comprising a component which is element-partitioned into two or more elements, for two of said elements having a boundary condition defined between two surfaces, said device comprising:

a data management unit for arranging a matrix-like data set by preparing a plurality of data columns wherein data items of multiple types are associated with each other, arranging a three-dimensionally arrayed data group by preparing a plurality of said data set, and managing information with regard to said elements.

Here, the numerical analysis aiding device may comprise a data management unit for arranging a matrix-like data set by preparing a plurality of data columns wherein data items of multiple types are associated with each other, arranging a three-dimensionally arrayed data group by preparing a plurality of said data set, and managing information with regard to said elements.

Additionally, the numerical analysis aiding method of the present invention is characterized in being a numerical analysis aiding method for verifying a boundary condition between surfaces forming a pair associated with each element in an analysis model comprising a component which is element-partitioned into two or more elements, for two of said elements having a boundary condition defined between two surfaces, said method comprising:

a space determination step for determining, with regard to a master surface to be verified among said two surfaces forming the pair, whether or not given slave nodes composing a slave surface other than said master surface among said two surfaces forming the pair are included in a check space formed by projecting said master surface to its normal direction; and

an interference determination step for calculating, if said slave nodes are determined to exist in said check space according to the determination of said space determination step, the distance between said master surface and said slave surface, and determining that interference is occurring if said distance is smaller than zero.

Furthermore, the numerical analysis aiding method of the present invention is characterized in being a numerical analysis aiding method for verifying a boundary condition between surfaces forming a pair associated with each element in an analysis model comprising a component which is element-partitioned into two or more elements, for two of said elements having a boundary condition defined between two surfaces, said method comprising:

a normal angle calculation step for calculating, based on the normal direction of a master surface to be verified among said two surfaces forming the pair and the normal direction of a slave surface other than said master surface among said two surfaces forming the pair, the normal angle formed by the normal of said master surface and the normal of said slave surface; and

a notification step for notifying information with regard to said angle calculated in said normal angle calculation step.

Additionally, the numerical analysis aiding method of the present invention is characterized in being a numerical analysis aiding method for verifying a boundary condition between surfaces forming a pair associated with each element in an analysis model comprising a component which is element-partitioned into two or more elements, for two of said elements having a boundary condition defined between two surfaces, said method comprising:

a space determination step for determining, with regard to a master surface to be verified among said two surfaces forming the pair, whether or not given slave nodes composing a slave surface other than said master surface among said two surfaces forming the pair are included in a check space formed by projecting said master surface to its normal direction;

an interference determination step for calculating, if said slave nodes are determined to exist in said check space according to the determination of said space determination step, the distance between said master surface and said slave surface, and determining that interference is occurring if said distance is smaller than zero; and

a normal angle calculation step for calculating a normal angle formed by the normal of said master surface and the normal of said slave surface, based on the normal directions of said master surface and said slave surface, respectively.

Additionally, the numerical analysis aiding program of the present invention is characterized in being a numerical analysis aiding program for instructing a computer to perform a numerical analysis aiding function for verifying a boundary condition between surfaces forming a pair associated with each element in an analysis model comprising a component which is element-partitioned into two or more elements, for two of said elements having a boundary condition defined between two surfaces, wherein the numerical analysis aiding program instructs the computer to function as:

a space determination unit for determining, with regard to a master surface to be verified among said two surfaces forming the pair, whether or not given slave nodes composing a slave surface other than said master surface among said two surfaces forming the pair are included in a check space formed by projecting said master surface to its normal direction; and

an interference determination unit for calculating the distance between said master surface and said slave surface if said slave nodes are determined to exist in the check space according to the determination of said space determination unit, and determining that interference is occurring if said distance is smaller than zero.

Additionally, the numerical analysis aiding program of the present invention is characterized in being a numerical analysis aiding program for instructing a computer to perform a numerical analysis aiding function for verifying a boundary condition between surfaces forming a pair associated with each element in an analysis model comprising a component which is element-partitioned into two or more elements, for two of said elements having a boundary condition defined between two surfaces, wherein the numerical analysis aiding program instructs the computer to function as:

a normal angle calculation unit for calculating a normal angle formed by the normal of a master surface to be verified among said two surfaces forming the pair and the normal of a slave surface other than said master surface among said two surfaces forming the pair, based on the normal directions of said master surface and said slave surface, respectively.

Additionally, the numerical analysis aiding program of the present invention is characterized in being a numerical analysis aiding program for instructing a computer to perform a numerical analysis aiding function for verifying a boundary condition between surfaces forming a pair associated with each element in an analysis model comprising a component which is element-partitioned into two or more elements, for two of said elements having a boundary condition defined between two surfaces, wherein the numerical analysis aiding program instructs the computer to function as:

a space determination unit for determining, with regard to a master surface to be verified among said two surfaces forming the pair, whether or not given slave nodes composing a slave surface other than said master surface among said two surfaces forming the pair are included in a check space formed by projecting said master surface to its normal direction;

an interference determination unit for calculating the distance between said master surface and said slave surface if said slave nodes are determined to exist in the check space according to the determination of said space determination unit, and determining that interference is occurring if said distance is smaller than zero; and
a normal angle calculation unit for calculating a normal angle formed by the normal of said master surface and the normal of said slave surface, based on the normal directions of said master surface and said slave surface, respectively.

Additionally, the numerical analysis aiding program of the present invention is characterized in being a numerical analysis aiding program for instructing a computer to perform a numerical analysis aiding function for verifying a boundary condition between surfaces forming a pair associated with each element in an analysis model comprising a component which is element-partitioned into two or more elements, for two of said elements having a boundary condition defined between two surfaces, wherein the numerical analysis aiding program instructs the computer to function as:

a data management unit for arranging a matrix-like data set by preparing a plurality of data columns wherein data items of multiple types are associated with each other, arranging a three-dimensionally arrayed data group by preparing a plurality of said data set, and managing information with regard to said elements.

Here, the numerical analysis aiding program of the present invention may instruct a computer to function as a data management unit for arranging a matrix-like data set by preparing a plurality of data columns wherein data items of multiple types are associated with each other, arranging a three-dimensionally arrayed data group by preparing a plurality of said data set, and managing information with regard to said elements.

A computer readable recording medium of the present invention is characterized in being a computer readable recording medium having a numerical analysis aiding program recorded thereon for instructing a computer to perform a numerical analysis aiding function for verifying a boundary condition between surfaces forming a pair associated with each element in an analysis model comprising a component which is element-partitioned into two or more elements, for two of said elements having a boundary condition defined between two surfaces, wherein the numerical analysis aiding program instructs the computer to function as:

a space determination unit for determining, with regard to a master surface to be verified among said two surfaces forming the pair, whether or not given slave nodes composing a slave surface other than said master surface among said two surfaces forming the pair are included in a check space formed by projecting said master surface to its normal direction; and
an interference determination unit for calculating the distance between said master surface and said slave surface if said slave nodes are determined to exist in the check space according to the determination of said space determination unit, and determining that interference is occurring if said distance is smaller than zero.

Additionally, the computer readable recording medium of the present invention is characterized in being a computer readable recording medium having a numerical analysis aiding program recorded thereon for instructing a computer to perform a numerical analysis aiding function for verifying a boundary condition between surfaces forming a pair associated with each element in an analysis model comprising a component which is element-partitioned into two or more elements, for two of said elements having a boundary condition defined between two surfaces, wherein the numerical analysis aiding program instructs the computer to function as:

a normal angle calculation unit for calculating a normal angle formed by the normal of a master surface to be verified among said two surfaces forming the pair and the normal of a slave surface other than said master surface among said two surfaces forming the pair, based on the normal directions of said master surface and said slave surface, respectively.

Additionally, the computer readable recording medium of the present invention is characterized in being a computer readable recording medium having a numerical analysis aiding program recorded thereon for instructing a computer to perform a numerical analysis aiding function for verifying a boundary condition between surfaces forming a pair associated with each element in an analysis model comprising a component which is element-partitioned into two or more elements, for two of said elements having a boundary condition defined between two surfaces, wherein the numerical analysis aiding program instructs the computer to function as:

a space determination unit for determining, with regard to a master surface to be verified among said two surfaces forming the pair, whether or not given slave nodes composing a slave surface other than said master surface among said two surfaces forming the pair are included in a check space formed by projecting said master surface to its normal direction;
an interference determination unit for calculating the distance between said master surface and said slave surface if said slave nodes are determined to exist in the check space according to the determination of said space determination unit, and determining that interference is occurring if said distance is smaller than zero; and
a normal angle calculation unit for calculating a normal angle formed by the normal of said master surface and the normal of said slave surface, based on the normal directions of said master surface and said slave surface, respectively.

Additionally, the computer readable recording medium of the present invention is characterized in being a computer readable recording medium having a numerical analysis aiding program recorded thereon for instructing a computer to perform a numerical analysis aiding function for verifying a boundary condition between surfaces forming a pair associated with each element in an analysis model comprising a component which is element-partitioned into two or more elements, for two of said elements having a boundary condition defined between two surfaces, wherein the numerical analysis aiding program instructs the computer to function as:

a data management unit for arranging a matrix-like data set by preparing a plurality of data columns wherein data items of multiple types are associated with each other, arranging a three-dimensionally arrayed data group by preparing a plurality of said data set, and managing information with regard to said elements.

Here the numerical analysis aidingprogrammay instruct a computer to function as a data management unit for arranging amatrix-like data set by preparing a plurality of data columns wherein data items of multiple types are associated with each other, arranging a three-dimensionally arrayed data group by preparing a plurality of said data set, and managing information with regard to said elements.
The following effects and/or advantages canbe obtained according to the present invention.

(1) Boundary conditions in the analysis model can be checked before performing numerical analysis by the solver, thereby reducing design time as well as facilitating early detection of mistakes and cutting man-hours.
(2) Data items of multiple types can be uniformly managed and the data can also be compared with each other easily, by arranging a matrix-like data set by preparing a plurality of data columns wherein data items of multiple types are associated with each other, arranging a three-dimensionally arrayed data group by preparing a plurality of the data set, and managing information with regard to the elements.

BRIEF DESCRIPTION OF THE DRAWINGS

Fig. 1 is a block diagram showing an arrangement of the numerical simulation system as an embodiment of the present invention.
Fig. 2 is a diagram showing an exemplary analysis model for performing numerical simulation in the numerical simulation system as an embodiment of the present invention.
Fig. 3 is a side view of the analysis model shown in Fig. 2.
Fig. 4 is a plan view of the analysis model shown in Fig. 2.
Fig. 5 is a diagram showing an exemplary data read screen in the numerical simulation system as an embodiment of the present invention.
Fig. 6 is a diagram showing an exemplary check space formed by the space determination unit of the numerical simulation system as an embodiment of the present invention.
Fig. 7 is a diagram showing an exemplary definition of array FILE used in the numerical simulation system as an embodiment of the present invention.
Fig. 8 is a diagram showing an exemplary definition of array ELEM used in the numerical simulation system as an embodiment of the present invention.
Fig. 9 is a diagram showing an exemplary definition of array MAT used in the numerical simulation system as an embodiment of the present invention.
Fig. 10 is a diagram for explaining a three-dimensional array structure.
Fig. 11 is a diagram showing an exemplary definition of array NODE used in the numerical simulation system as an embodiment of the present invention.
Fig. 12 is a diagram showing an exemplary definition of array CONSURF used in the numerical simulation system as an embodiment of the present invention.
Fig. 13 is a diagram showing an exemplary definition of array CONTACT used in the numerical simulation system as an embodiment of the present invention.
Fig. 14 is a diagram showing an exemplary definition of array CONNODE used in the numerical simulation system as an embodiment of the present invention.

Fig. 15 is a diagram showing an exemplary definition of array RES used in the numerical simulation system as an embodiment of the present invention.

Fig. 16 is a diagram showing an exemplary definition of array RESV used in the numerical simulation system as an embodiment of the present invention.

Fig. 17 is a diagram showing an exemplary definition of array ELEMENT used in the numerical simulation system as an embodiment of the present invention.

Fig. 18 is a diagram showing an exemplary selection screen in the numerical simulation system as an embodiment of the present invention.

Fig. 19 is a diagram showing an exemplary list screen in the numerical simulation system as an embodiment of the present invention.

Fig. 20 is a diagram showing an exemplary element confirming screen in the numerical simulation system as an embodiment of the present invention.

Fig. 21 is a diagram showing an exemplary contact screen in the numerical simulation system as an embodiment of the present invention.

Fig. 22 is a diagram showing an exemplary contact list screen in the numerical simulation system as an embodiment of the present invention.

Fig. 23 is a diagram showing an exemplary error detail screen in the numerical simulation system as an embodiment of the present invention.

Fig. 24 is a diagram showing an exemplary history screen in the numerical simulation system as an embodiment of the present invention.

Figs. 25 (a) and (b) are diagrams showing an exemplary history list screen in the numerical simulation system as an embodiment of the present invention.

Figs. 26(a) and (b) are diagrams showing an exemplary a result list presentation screen in the numerical simulation system as an embodiment of the present invention.

Fig. 27 is a flow chart for explaining the general flow of the simulation in the numerical simulation system as an embodiment of the present invention.

Fig. 28 is a flow chart for explaining the process associated with acquisition of analysis model data by the analysis model acquisition unit in the numerical simulation system as an embodiment of the present invention.

Fig. 29 is a flow chart for explaining the method of generating element group data in the numerical simulation system as an embodiment of the present invention.

Fig. 30 is a flow chart for explaining the method of generating a contact surface and a perpendicular surface by the space determination unit of the numerical simulation system as an embodiment of the present invention.

Fig. 31 is a flow chart for explaining the method of generating a contact-point-pair-contact-surface in the numerical simulation system as an embodiment of the present invention.

Fig. 32 is a flow chart for explaining the method of checking a normal direction by the normal angle calculation unit in the numerical simulation system as an embodiment of the present invention.

Fig. 33 is a flow chart for explaining the method of checking the changes of the historical data in the numerical simulation system as an embodiment of the present invention.

DESCRIPTION OF THE PREFERRED EMBODIMENTS

Embodiments of the present invention will be explained below, referring to the drawings.

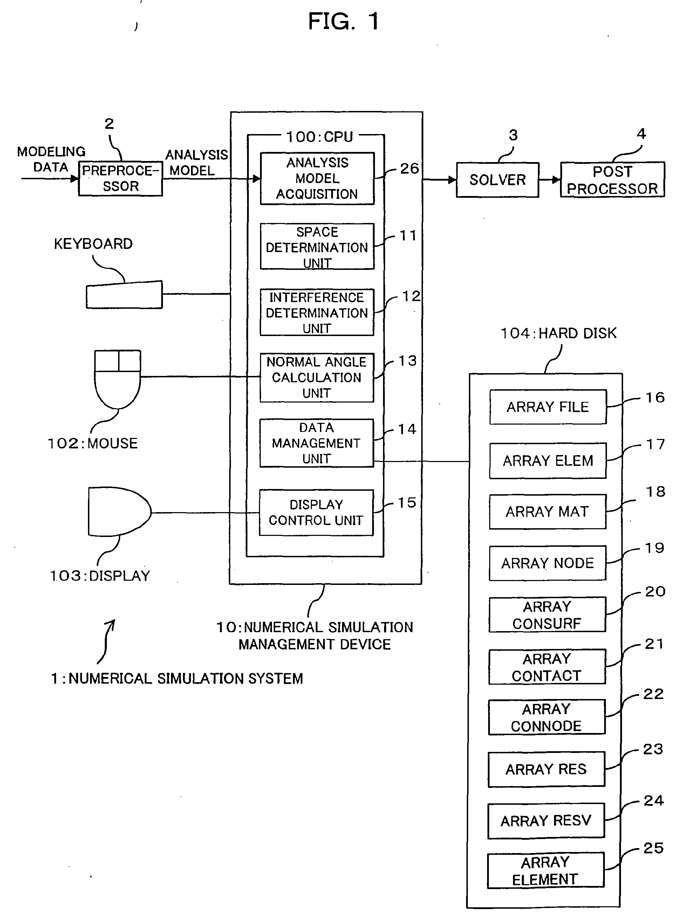

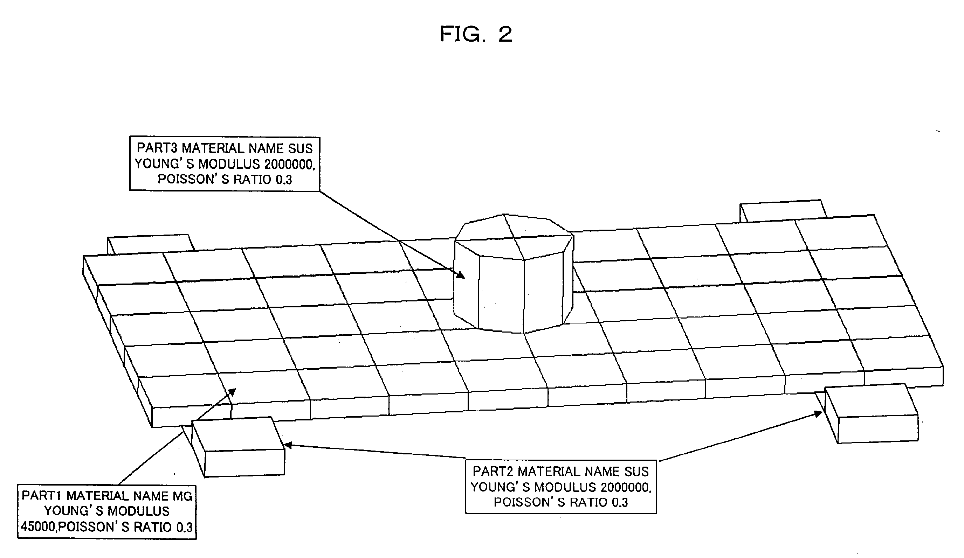

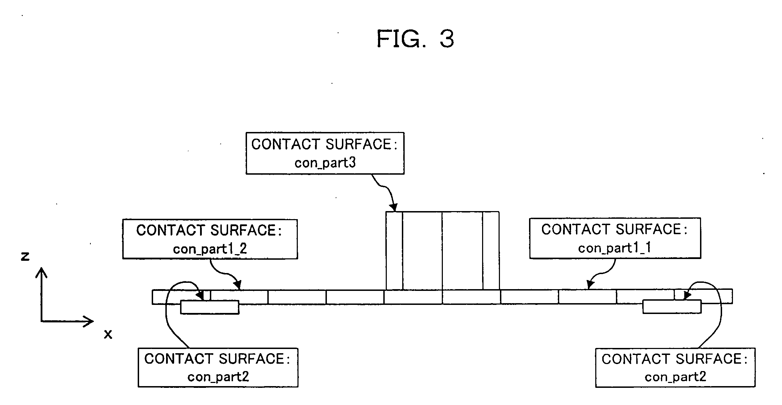

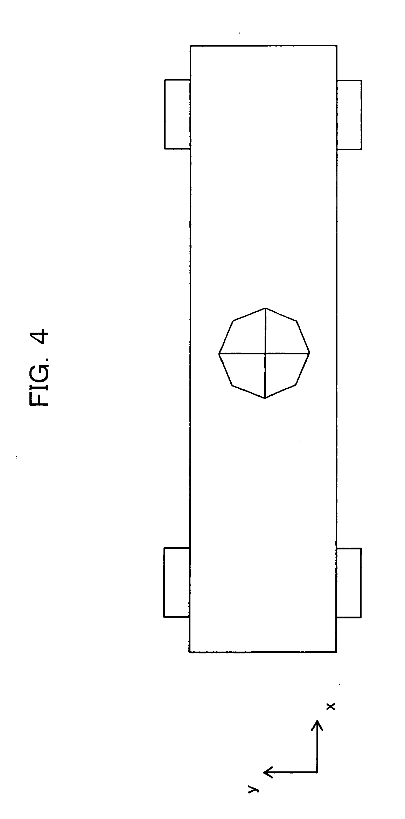

Fig. 1 is a block diagram showing an arrangement of the numerical simulation system as an embodiment of the present invention; Fig. 2 is a diagram showing an exemplary analysis model for performing numerical simulation in the numerical simulation system as an embodiment of the present invention; Fig. 3 is a side view of the analysis model shown in Fig. 2; and Fig. 4 is a plan view of the analysis model shown in Fig. 2.

The numerical simulation system 1, comprising, as shown in Fig. 1, a preprocessor 2, a numerical simulationmanagement device 10, a solver 3 and a post processor 4, generates an analysis model (see Figs. 2 to 4) by partitioning (mesh-creating) the modeling data generated by a three dimensional CAD{Computer Aided Design} system which is not shown, then, after having examined the boundary condition, performs simulation by performing various types of analytic and/or computational processes.

The preprocessor 2 generates an analysis model as shown in Figs. 2 to 4 by mesh-partitioning (mesh-creating) of the modeling data generated by a three-dimensional CAD system (not shown) into polyhedral minute elements (simply referred to as elements, hereafter) such as hexahedrons, pentahedrons or tetrahedrons, and passes the generated analysis model to the numerical simulation management device 10.

Here, in the examples of Figs. 2 to 4, an analysis model is shown to be constructed by combining a cylindrical PART 3 made of SUS having Young's modulus of 200,000 and Poisson's ratio of 0.3, two plate-like PARTs 2 made of SUS also having Young's modulus of 200,000 and Poisson's ratio of 0.3, and a plate-like PART1 made of MG having Young's modulus of 45, 000 and Poisson's ratio of 0.3. This analysis model has an arrangement wherein PART 1 is placed on two PARTs 2 which are disposed parallel to each other with a predefined interval, and PART 3 is further placed approximately at the center of PART1.

Also, in the present embodiment, contact definition is made between PART 1 and PART 3, and between PART 1 and PART 2, respectively, as shown in Fig. 2.

Here, in the example shown in Fig. 3, the top surface of PART 1 is configured as a contact surface con_part1-1 (surface group 2), the bottom surface of PART 1 is configured as a contact surface con_part1-2 (surface group 4), and each of the top surfaces of PARTs 2 is configured as a contact surface con_part2 (surface group 3), and besides, the contact definition of PART 3 is mistaken in that the top surface of PART 3 is defined as a contact surface con_part3 (surface group 1) instead of defining the bottom surface of PART 3 as the contact surface. Furthermore, in the examples shown in Figs. 2 to 4, PART 2 is penetrating into PART 1.

Here, the analysis model comprises a component which is element-partitioned into two or more elements, and, in the present embodiment, the preprocessor 2 performs partitioning into elements of a hexahedron, as shown in Figs. 2 to 4.

The numerical simulation management device (numerical analysis aiding device) 10 verifies the boundary condition between surfaces forming a pair (contact pair) associated with each element in this analysis model, for two of the elements having a contact definition, with regard to the analysis model generated by the preprocessor 2.

Here, in the analysis model, a contact pair can be defined, for example, by a command as shown below.

CONTACT PAIR B A

The above command example shows that surface A contacts surface B.

The numerical simulation management device 10, comprising, as shown in Fig. 1, a display 103, a keyboard 101, a mouse 102, a hard-disk 104 and a CPU 100, is configured as a personal computer which can realize various types of functions by performing the OS (Operating System) and various applications by means of the CPU (Central Processing Unit) 100.

The display 103, being composed of a CRT (Cathode Ray Tube) and an LCD (Liquid Crystal Display), for example, displays various types of information. Here, the display 103 is controlled by means of a display control unit 15 which will be described below.

The keyboard 101 is used by the operator for key-inputting various types of information, and the mouse 102 is used by the operator for moving the cursor (not shown) displayed on the display 103 to perform various types of selection and/or input operation.

The hard-disk 104, being a storage device which can writably and readably store the OS and various types of data or application, is configured to store, as shown in Fig. 1, array FILE 16, array ELEM 17, array MAT 18, array NODE 19, array CONSURF 20, array CONTACT 21, array CONNODE 22, array RES 23, array RESV 24 and array ELEMENT 25 described below.

The CPU 100, realizing various types of functions by executing OS and various types of application recorded in the hard-disk 104 or other storage devices (memory, etc.) not shown. The CPU 100 in the present embodiment is configured to function as a space determination unit 11, an interference determination unit 12, a normal angle calculation unit 13, a data management unit 14, a display control unit 15 and an analysis model acquisition unit 26, by executing a numerical analysis aiding program.

Here, a program (numerical analysis aiding program) for realizing the functions as the space determination unit 11, the interference determination unit 12, the normal angle calculation unit 13, the data management unit 14, the display control unit 15 and the analysis model acquisition unit 26 is provided in a recorded formon a computer readable recording medium such as, for example, a flexible disk, a CD (CD-ROM, CD-R, CD-RW etc.), a DVD (DVD-ROM, DVD-RAM, DVD-R, DVD+R, DVD-RW, DVD+RW etc.), a magnetic disk, an optical disk and a magneto-optical disk. The computer then uses the program by reading it from the recording medium, transferring it to an internal or external storage device, and storing it therein. The programmay also be recorded in a storage device (recording medium) such as a magnetic disk, an optical disk, a magneto-optical disk and provided from the storage device to the computer via a communication channel.

When realizing the functions as the space determination unit 11, the interference determination unit 12, the normal angle calculation unit 13, the data management unit 14, the display control unit 15 and the analysis model acquisition unit 26, the program stored in the internal storage device (RAM and ROM (not shown) of the numerical simulation management device 10, in the present embodiment) is executed by the microprocessor (CPU 100, in the present embodiment) . In this case the computer may read the program recorded in the recording medium and execute it.

Here, in the present embodiment, the term computer is a concept including hardware and an operating system which means hardware operating under control of the operating system. Additionally, the hardware itself corresponds to the computer when an operating system is unnecessary and the application program alone operates the hardware. The hardware includes at least a microprocessor such as the CPU and a means for reading a computer program recorded in a recording medium, and, in the present embodiment, the information processor 1 has the function as the computer.

Furthermore, as the recording medium in the present embodiment, an IC card, a ROM cartridge, a magnetic tape, a punch card, an internal storage device (a memory such as RAM and ROM) of a computer, an external storage, or various types of computer readable media including printed matters having codes such as bar codes printed thereon can be used, other than the above- mentioned flexible disc, CD, DVD, magnetic disk, optical disk and magneto-optical disk.

The analysis model acquisition unit 26 acquires the analysis model generated by the pre-processor 2.

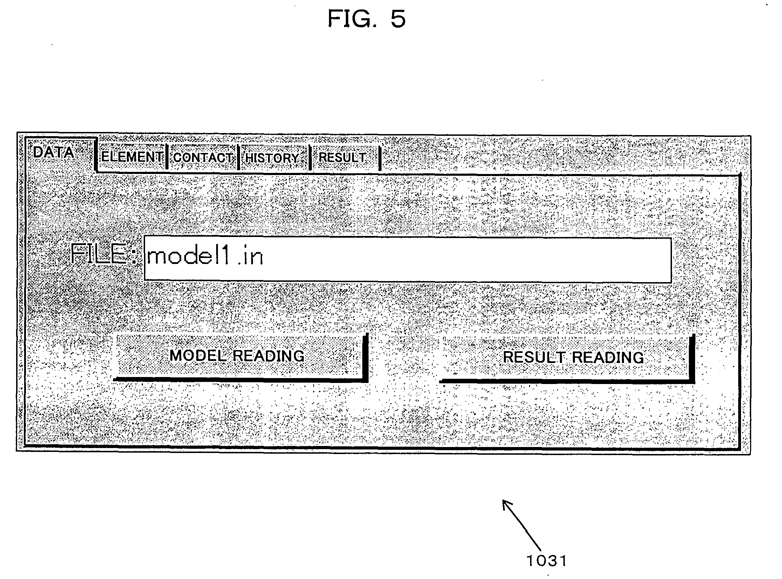

Fig. 5 is a diagram showing an exemplary data reading screen in the numerical simulation system 1 as an embodiment of the present invention. In the numerical simulation system 1, the analysis model acquisition unit 26 is configured to present, on the display 103, a display data reading screen 1031 as shown in Fig. 5 via the display control unit 15.

The data reading screen 1031 includes fields (FILE field in the example shown in Fig. 5) for entering the filename (also referred to as the analysis input filename in the following) of the analysis model generated by the preprocessor 2 or the result of analysis performed by the postprocessor 4. The operator inputs the filename of or the path to the data of the analysis model and selects the "read-in model" button in the data reading screen 1031 to import the analysis model into the numerical simulation management device 10. Here, Fig. 5 shows an example wherein the analysis model having a filename "modell.in" is loaded.

Similarly, the operator inputs the filename of, as well as the path to, the result data of the analysis performed by the solver 3 in the FILE field and selects the "read-in results" button in the data reading screen 1031 to import the analysis result data into the numerical simulation management device 10.

The space determination unit 11 determines, for the elements composing the analysis model and with regard to a master surface to be verified among a plurality (six, in the present embodiment) of surfaces composing the element (a hexahedron, in the present embodiment), whether or not given slave nodes composing a slave surface are included in a check space formed by projecting the master surface to its normal direction,

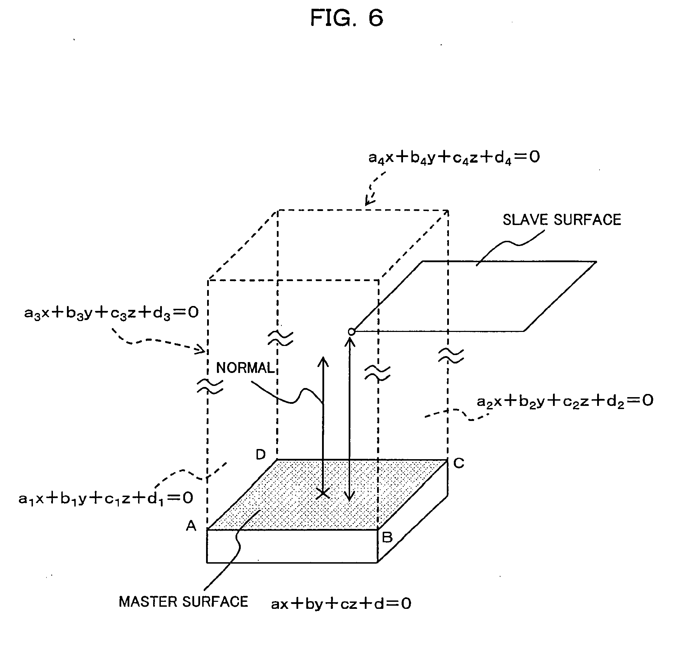

Fig. 6 is a diagram showing an exemplary check space formed by the space determination unit 11 of the numerical simulation system 1 as an embodiment of the present invention.

The space determination unit 11 generates, with regard to a master surface (in some cases also referred to as a contact surface in the following) composed of four nodes A, B, C and D, a space (contact space) enveloped by the contact surface and additionally generated perpendicular surfaces which are, respectively, a surface including the edge AB and having a normal perpendicular to the normal of contact surface; a surface including the edge BC and having a normal perpendicular to the normal of contact surface; and a surface including the edge CD, having a normal perpendicular to the normal of contact surface, and having a normal direction facing inward the check space.

Here, the, master surface and each perpendicular surface can be expressed by the equations (1)-(5) shown below, based on the respective coordinates of nodes A, B, C and D.

$$\text{master surface (contact surface): } ax + by + cz + d = 0 \quad (1)$$

$$\text{perpendicular surface including edge AB: } a_1x + b_1y + c_1z + d_1 = 0 \quad (2)$$

$$\text{perpendicular surface including edge BC: } a_2x + b_2y + c_2z + d_2 = 0 \quad (3)$$

$$\text{perpendicular surface including edge CD: } a_3x + b_3y +$$

$$c_3z + d_3 = 0 \ (4)$$

$$\text{perpendicular surface including edge DA: } a_4x + b_4y +$$

$$c_4z + d_4 = 0 \ (5),$$

where a, b, c and d are coefficients (contact surface coefficients) for specifying the master surface (contact surface), and $a_1, a_2, a_3, a_4, b_1, b_2, b_3, b_4, c_1, C_2, C_3, C_4, d_1, d_2, d_3$ and $d_4$ are coefficients (perpendicular coefficients)for specifying each perpendicular surfaces.

The space determination unit 11 then determines whether or not given nodes (in some cases also referred to as slave nodes in the following) composing a slave surface other than the master surface among the two surfaces forming the contact pair are included in a check space enveloped by the contact surface and the perpendicular surface.

Here, in the present embodiment, the master surface is the surface which prevents occurrence of penetration at the contact pair, and the surface contacting the master surface is the slave surface.

The interference determination unit 12 calculates the distance between the master surface and the slave surface if the slave nodes are determined to exist in the check space according to the determination of the space determination unit 11, and determines that interference (penetration)is occurring if the distance is smaller than zero.

The normal angle calculation unit 13 for calculating the normal angle formed by the normal of the master surface and the normal of the slave surface based on the normal directions of the master surface and the slave surface, calculates each normal direction based on the coordinates of each node composing the master surface and the coordinates of each slave node composing the slave surface to determine the angle formed by these normals.

The data management unit 14 for, managing various types of data used in the numerical simulation system 1, manages, in particular, array FILE 16, array ELEM 17, array MAT 18, array NODE 19, array CONSURF 20, array CONTACT 21, array CONNODE 22, array RES 23, array RESV 24 and array ELEMENT 25 stored in the hard-disk 104.

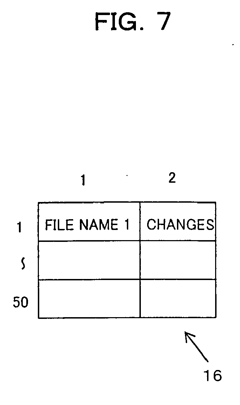

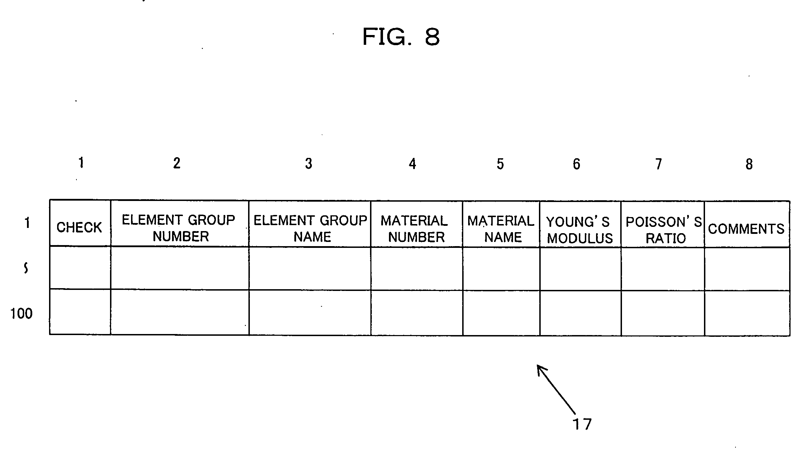

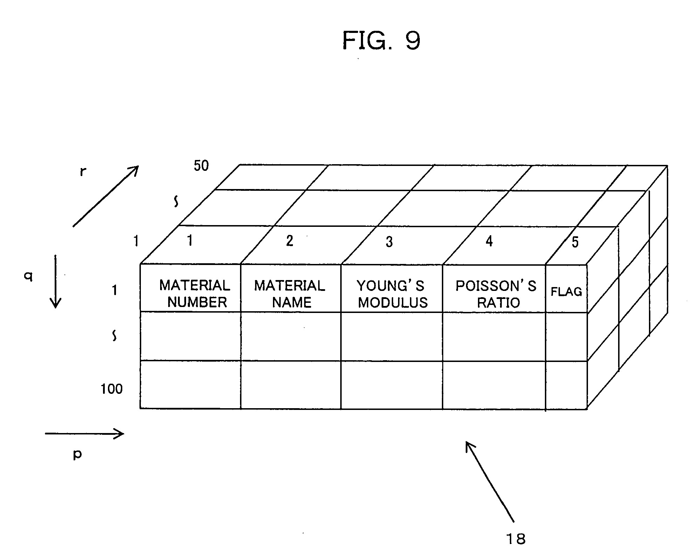

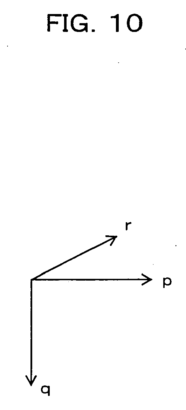

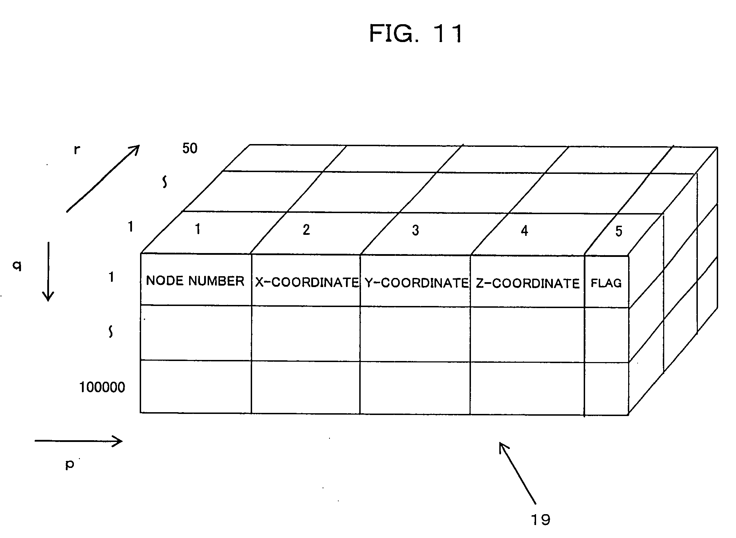

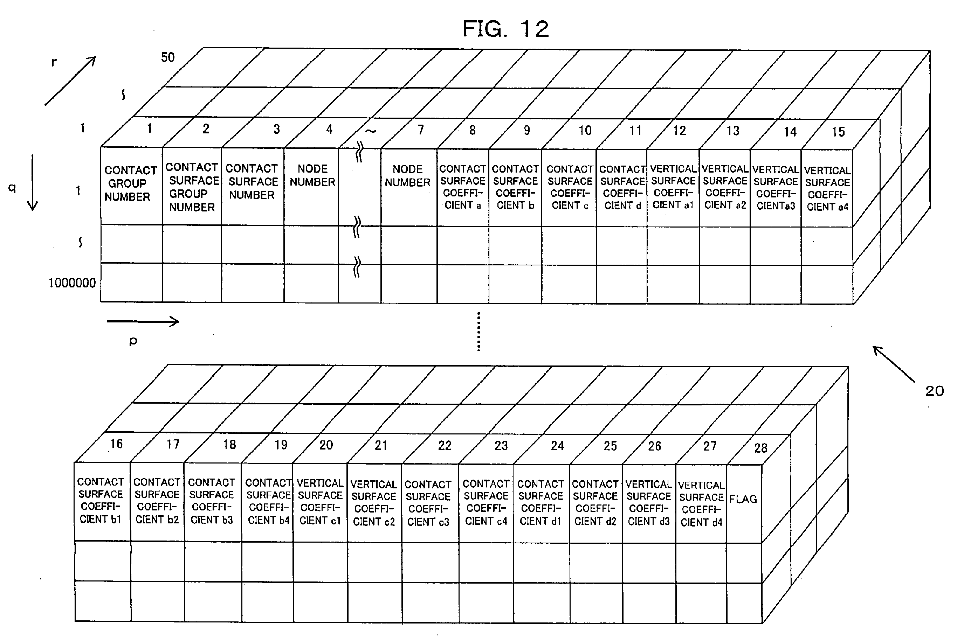

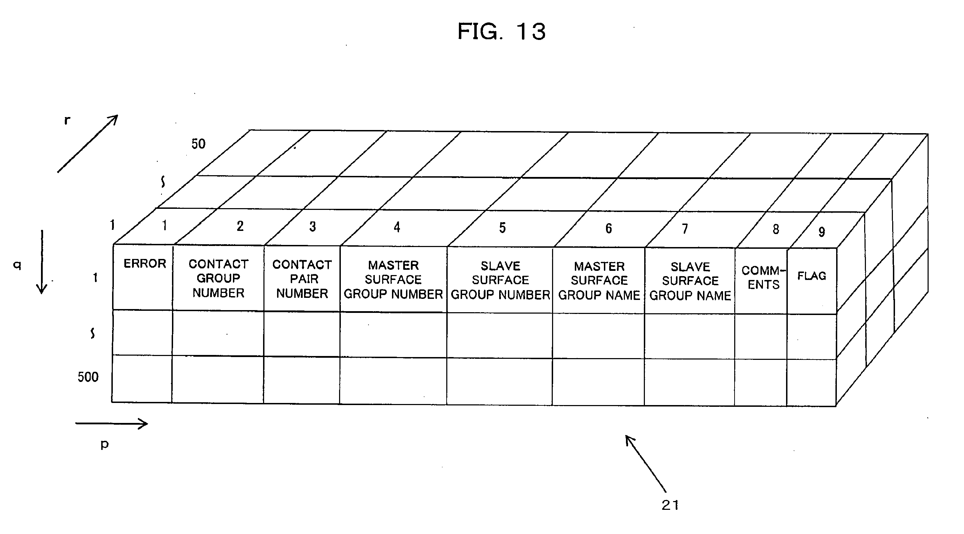

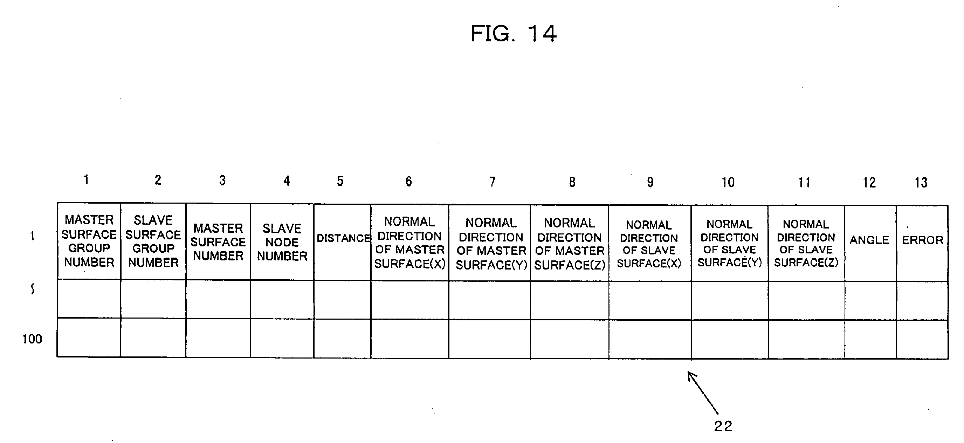

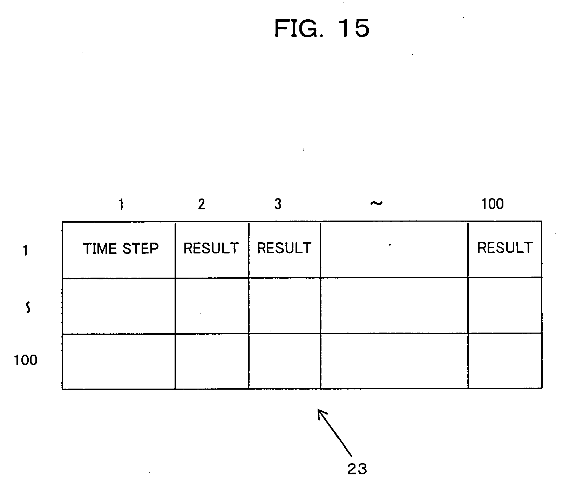

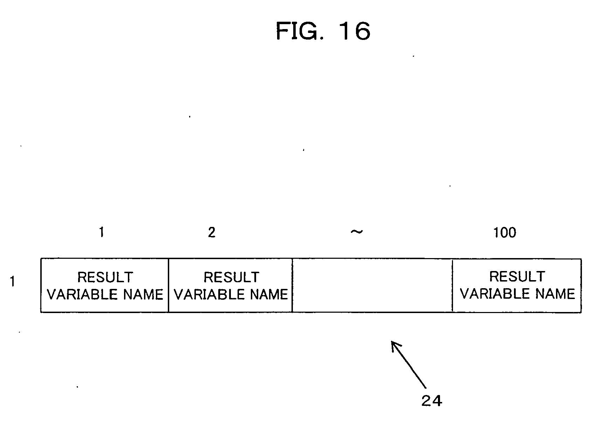

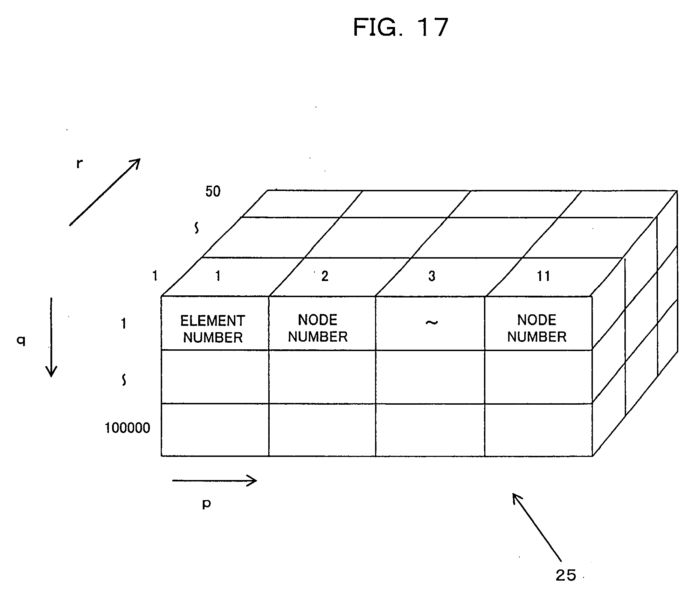

Fig. 7 is a diagram showing an exemplary definition of array FILE used in the numerical simulation system 1 as an embodiment of the present invention; Fig. 8 is a diagram showing an exemplary definition of array ELEM used in the numerical simulation system 1 as an embodiment of the present invention; Fig. 9 is a diagram showing an exemplary definition of array MAT used in the numerical simulation system 1 as an embodiment of the present invention; Fig. 10 is a diagram for explaining a three-dimensional array structure; Fig. 11 is a diagram showing an exemplary definition of array NODE used in the numerical simulation system 1 as an embodiment of the present invention; Fig. 12 is a diagram showing an exemplary definition of array CONSURF used in the numerical simulation system 1 as an embodiment of the present invention; Fig. 13 is a diagram showing an exemplary definition of array CONTACT used in the numerical simulation system 1 as an embodiment of the present invention; Fig. 14 is a diagram showing an exemplary definition of array CONNODE used in the numerical simulation system 1 as an embodiment of the present invention; Fig. 15 is a diagram showing an exemplary definition of array RES used in the numerical simulation system 1 as an embodiment of the present invention; Fig. 16 is a diagram showing an exemplary definition of array RESV used in the numerical simulation system 1 as an embodiment of the present invention; and Fig. 17 is a diagram showing an exemplary definition of array ELEMENT used in the numerical simulation system 1 as an embodiment of the present invention.

Here, in the drawings, since the reference numerals identical to existing numerals indicate identical or substantially identical members, their detailed description will be omitted.

Array FILE 16, for storing as shown in Fig. 7 the analysis input filename (filename) in association with the changes, is arranged as a two-dimensional array structure. Here, the changes field stores information which indicates the changes made to the analysis input file, that is, for example, information entered by the operator using the keyboard 101.

Here, in the present embodiment, the storage location of respective information is expressed by the suffixes in natural numbers along the vertical axis and the horizontal axis in the figures showing the two-dimensional array structure (Fig. 7, Fig. 8, Figs. 14 to 16).

In the numerical simulation system 1, a plurality of elements composing the same component or a plurality of elements made from the same material are treated as a same group (element group).

Array ELEM 17 is arranged, for every such element group, in association with the element group number provided to identify the group, and the name of the element group (element group name), the material number, the material name, Young's modulus and Poisson's ratio of the material and optional comments entered, as shown in Fig. 8.

Here, physical properties of the material number in array ELEM 17, that is, the material name, Young's modulus and Poisson' s ratio are taken out from array MAT 18 described below and stored.

The data management unit 14 reads array ELEM 17, extracts from array MAT 18 the physical properties of the material number stored array ELEM 17, and completes array ELEM 17 it in array ELEM 17.

Array MAT 18, for temporarily storing and managing the information (temporary storage region) with regard to the material, is arranged as a matrix-like data set by preparing, for each material number, a data column arranged by associating the material number with the material name, Young's modulus, Poisson's ratio and a flag, as shown in Fig. 9.

In addition, array MAT 18 is arranged as a three-dimensional array structure wherein a plurality of matrix-like data sets are layered as shown in Fig. 9. The three-dimensional array structure is arranged, as shown in Fig. 10, by placing the data along the axial directions of the p-axis, the q-axis and the r-axis which are perpendicular to each other.

Here, in the example shown in Fig. 9, a matrix-like data set is formed by defining, along the p-axis, a data column by associating the material number with the material name, Young's modulus, Poisson's ratio and a flag, and placing the data column along the q-axis for every material number. Array MAT 18 is further arranged by placing a plurality of the data set along the r-axis.

In addition, the plurality of data sets to be placed along the r-axis are formed, for example, if any change is made to the data set, by placing the data set of the changed version along the r-axis in time series against the data set before the change. Thus, in array MAT 18, the history of each data composing the data set are placed in time series along the r-axis, whereby the data set before the change (original data) and the data set after the change (new data) can be readily compared and the difference between the original data and the new data can be automatically recognized, facilitating unified management of the historical data.

In other words, array MAT 18 stores and manages information with regard to the materials of the elements by arranging a matrix-like data set by preparing a plurality of data columns wherein data items of multiple types are associated with each other, and arranging a three-dimensionally arrayed data group by preparing a plurality of the data set.

In addition, the flag is automatically set to "1", for example, by the data management unit 14 if any change and/or modification is made to the data set composing array MAT 18, and the fact that a change and/or modification is made to the data can be recognized by the flag.

In such a three-dimensional array structure, the storage location of each data can be identified by coordinates (p, q, r).Here, in the present embodiment, natural numbers are used as p, q and r, respectively, and furthermore, storage location of respective information is expressed by suffixes placed along respective axial directions of p, q and r, in the figures (Fig. 9, Fig. 11, Fig. 12, Fig. 13 and Fig. 17) showing the three-dimensional array structure.

Array NODE 19, for managing the position (coordinate value) of each node, is arranged as a three-dimensional array structure as with array MAT 18. In other words, array NODE 19 is arranged, as shown in Fig. 11, by defining a data column along the p-axis by associating every number identifying each node (node number) with the coordinates (x, y, z) and a flag, placing the data column along the q-axis for every node number to formamatrix-like data set, and further placing a plurality of the data set along the r-axis.

Here, since the reference numerals identical to existing numerals indicate identical or substantially identical fields in respective arrays, their detailed description will be omitted.

Array CONSURF 20, for managing data with regard to the contact surface, is arranged as a three-dimensional array structure as with array MAT 18. In other words, array CONSURF 20 is arranged, as shown in Fig. 12, by defining a data column along the p-axis by associating the contact group number with a contact surface group number, a contact surface number, a node number, a contact surface coefficient, a perpendicular surface coefficient and a flag, and placing the data column along the q-axis for every contact group number, contact surface group number and contact surface number to form a matrix-like data set, and further placing a plurality of the data set along the r-axis.

Here, the contact group number, being a number set for convenience to identify a defined contact, is set for a contacting component, for example. The contact surface group number is a number set for convenience for surfaces (group) of a plurality of elements. The contact surface number is a number set for convenience to identify individual surfaces composing an element, and the node number is a number for identifying a contact point composing the contact surface. The contact surface coefficients are, specifically, coefficients a, b, c and d used in the equation (1) expressing the above-mentioned contact surface, and the perpendicular surface coefficients are coefficients $a_1$, $a_2$, $a_3$, $a_4$, bi, $b_2$, $b_3$, $b_4$, $c_1$, $C_2$, $C_3$, $C_4$, $d_1$, $d_2$, $d_3$ and $d_4$ used in the equations (2) to (5) expressing the above-mentioned contact surface.

Array CONTACT 21, for managing data with regard to the contact surface, is arranged as a three-dimensional array structure as with array MAT 18. In other words, array CONTACT 21 is arranged, as shown in Fig. 13, by defining a data column along the p-axis by associating the contact group number with an error, a contact surface pair number, a master surface group number, a slave surface group number, a master surface group name, a slave surface group name, comments and a flag, and placing the data column along the q-axis for every contact group number and contact pair number to form a matrix-like data set, and further placing a plurality of the data set along the r-axis.

Here, the contact pair number is a number set for convenience to identify a contact pair, the master surface group number is a number set for convenience for the master surface, and the master surface group name is a name set for its master surface group number. The slave surface group number is a number set for convenience for the slave surface and the slave surface group name is a name set for its slave surface group number. A comment is an optional information which may be entered by the operator with regard to the master surface, etc.

In addition, an error code indicating the error type is stored in the error field. More specifically, an error code "11" (angle and penetration error) will be set by the data management unit 14 if interference is determined to be occurring in a contact pair from the result of the interference check by the interference determination unit 12, or if, for example, the normal angle has an error (normal angle = 0) and penetration is occurring (negative distance) in the result of calculation of the normal angle by the normal angle calculation unit 13, whereas an error code "01" (penetration error) will be set by the data management unit 14 if only the penetration is occurring.

Array CONNODE 22, for managing data with regard to contact nodes, is arranged by associating it with a master surface group number, a slave surface group number, a master surface number, a slave node number, distance, a normal direction (X) of the master surface, a normal direction (Y) of the master surface, a normal direction (Z) of the master surface, a normal direction (X) of the slave surface, a normal direction (Y) of the slave surface, a normal direction (Z) of the slave surface, an angle and an error, as shown in Fig. 14.

Here, the slave node number is the numbering of a node (slave node) composing the slave surface and the distance is the distance between the slave node and the master surface. The normal direction (X) of the master surface is the X component of the normal direction of the master surface when expressed as a vector, the normal direction (Y) of the master surface is the Y component of the normal direction of the master surface when expressed as a vector, and the normal direction (Z) of the master surface is the Z component of the normal direction of the master surface when expressed as a vector.

The normal direction (X) of the slave surface is the X component of the normal direction of the slave surface when expressed as a vector, the normal direction (Y) of the slave surface is the Y component of the normal direction of the slave surface when expressed as a vector, and the normal direction (Z) of the slave surface is the Z component of the normal direction of the slave surface when expressed as a vector. In addition, the angle formed by the normal of the master surface and the normal of the slave surface is stored in the angle field.

Array RES 23, for storing the analysis result data by the solver 3, is arranged, as shown in Fig. 15, by associating the time step with the results (result 1, 2...). Here, the time step is the total sum of the time counts in the analysis. For example, if the time step for a deformation of 1 mm is defined tobe 1, the time step for a 0.5 mm deformation is 0.5. In addition, since the result is a value obtained from the analysis by the solver 3, results of various numbers, i.e., 1 or higher, may be obtained according to the type or purpose of the solver 3.

Array RESV 24, being the information with regard to the result in array RES 23, is provided with the same number of result variable names as the number of result items in array RES 23 for storing the information specifying which of the one or more results in array RES 23 corresponds to what type of analysis result, such as displacement or stress, as shown in Fig. 16.

Array ELEMENT 25, for managing the nodes composing an element, is arranged as a three-dimensional array structure as with arrayMAT 18. In other words, array ELEMENT 25 is arranged, as shown in Fig. 17, by defining a data column along the p-axis by associating the element number set for identifying an element with a plurality of node numbers composing the element and a flag, and placing the data column along the q-axis for every element number to formamatrix-like data set, and further placing a plurality of the data set along the r-axis. Here, in the example shown in Fig. 17, a case is illustrated wherein an element is composed by eight nodes.

Here, the above-mentioned array MAT 18, array NODE 19, array ELEM 17, array CONTACT 21 and array CONSURF 20 are generated by reading the analysis model data acquired from the analysis input data file by the analysis model acquisition unit 26 wherein each value will be stored by ascending order of each number.

The display control unit (notification unit) 15, for controlling the display 103 to present various types of information on the display 103, is configured to present on the display 103, for example, various types of result display screens notifying the result to the operator, or a command input screen for the operator to input instructions or perform selection.

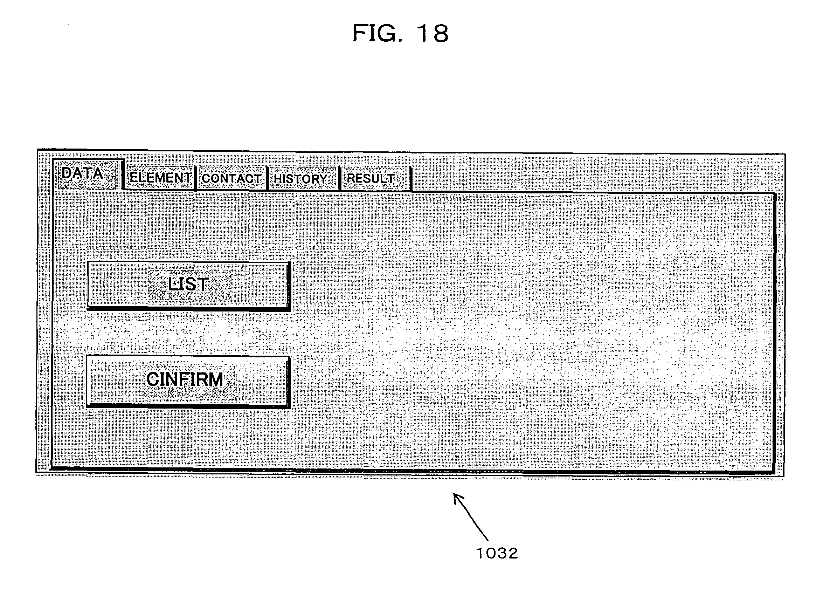

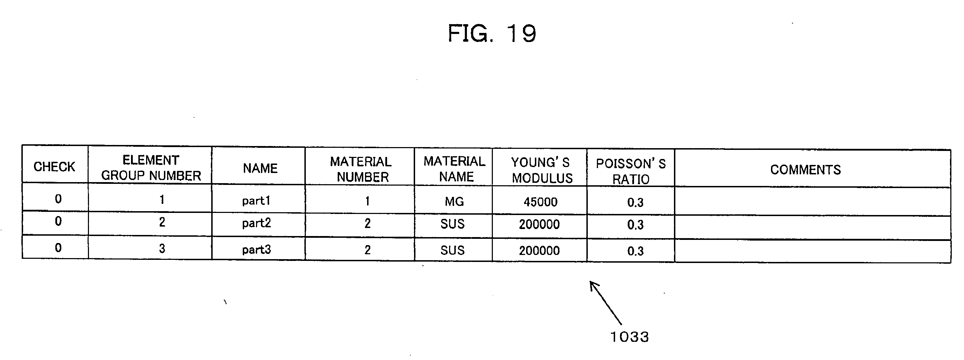

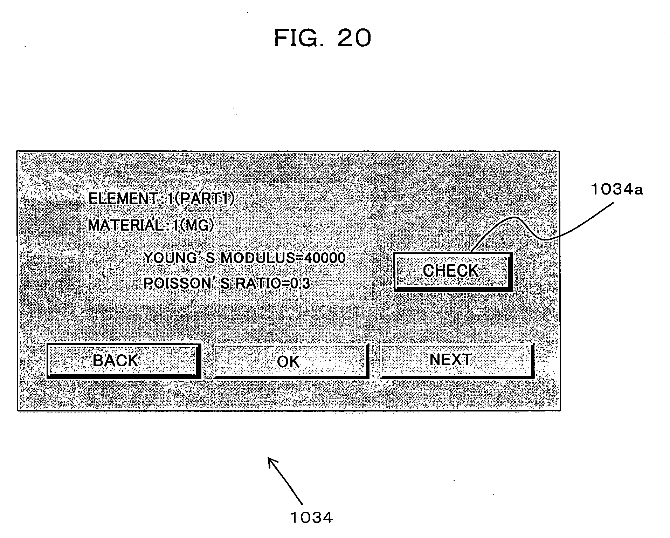

Fig. 18 is a diagram showing an exemplary selection screen 1032 for selecting a display method of the information with regard to an element, which is presented on the display 103 in the numerical simulation system 1 as an embodiment of the present invention; Fig. 19 is a diagram showing information with regard to the element as an exemplary list screen 1033; Fig. 20 is a diagram showing an exemplary element confirmation screen 1034 which separately shows the information with regard.to the element.

The display control unit 15 allows the operator to select a presentation form of the information relating to the element by presenting on the display 103 a selection screen 1032 such as shown in Fig. 18, and present, on the display 103, a list screen 1033 such as shown in Fig. 19 when the operator selected "list".

The list screen 1033 shown in Fig. 19, showing the content of array ELEM 17, presents an element group number in association with a check, anidentifier, a material number, a material name, Young's modulus, Poisson's ratio and comment, in the example shown in Fig. 19. Here, in the example shown in Fig. 19, the element group name in array ELEM 17 is presented as the name.

Additionally, in the list screen 1033, the operator can input and/or edit the comments and the like so that the operator can, upon notice of any mistake, correct it immediately, thereby providing enhanced convenience.

Furthermore, in the display screen 1032 shown in Fig. 18, the display control unit 15 is configured to present, when the operator selected "identification", an element confirmation screen 1034 on the display 103, as shown in Fig. 20. In the element confirmation screen 1034, element groups and materials are presented one by one so that the operator can confirm, for individual element groups, information with regard to the materials.

Here, in Figs. 19 and 20, although Young's modulus of the element 1 (PART1) is mistakenly registered as 4500 instead of 40000, it can be corrected later by selecting a check button 1034a in the element confirmation screen 1034 of Fig. 20 to set a flag "1" to the check field of array ELEM 17, for example. This enhances convenience in a case where the operator noticed a mistake but cannot immediately correct it, by setting a flag to instruct the correction later. Here, such a correction can be directly made in the list screen 1033 shown in Fig. 19.

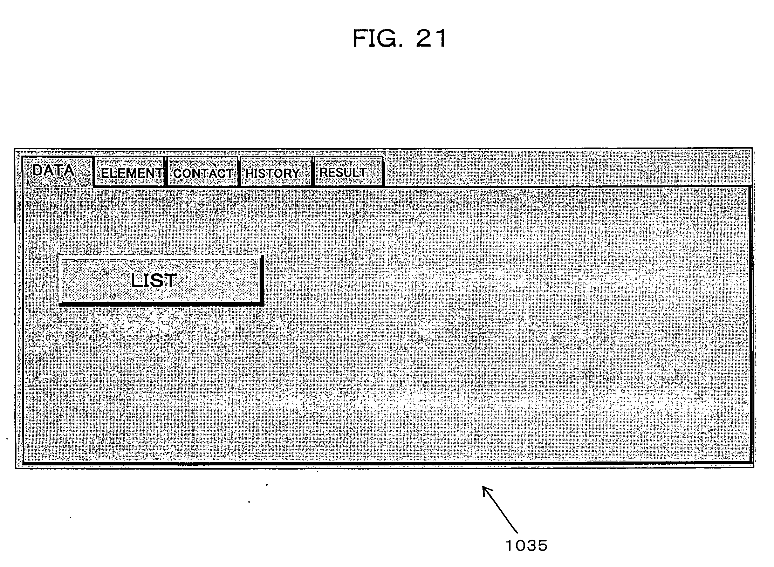

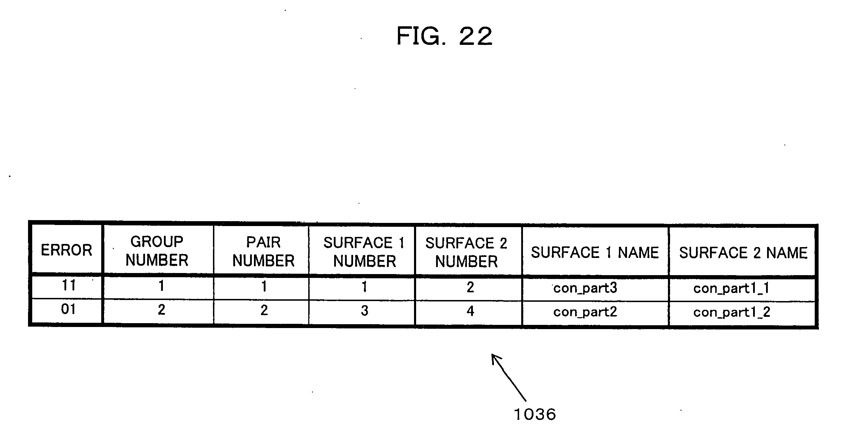

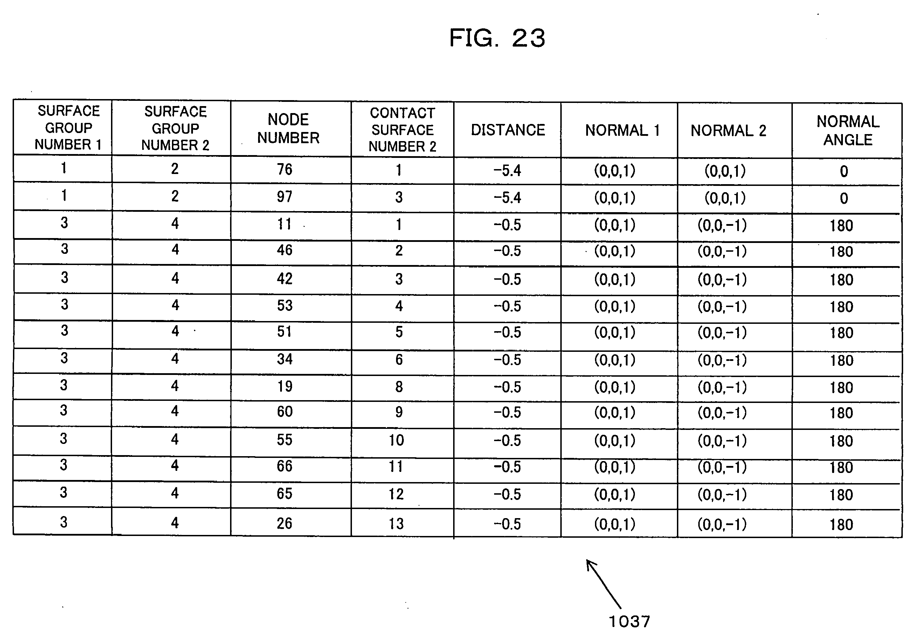

In addition, Fig. 21 is a diagram showing an exemplary contact screen 1035 for entering presentation instructions of the information with regard to a contact to be presented on the display 103 of the numerical simulation system 1 as an embodiment of the present invention; Fig. 22 is a diagram showing the information with regard to the contact as an exemplary contact list screen 1036; and Fig. 23 is a diagram showing an exemplary error detail screen 1037.

The display control unit 15 is configured to present, on the display 103, a contact screen 1035 such as shown in Fig. 21, and present, on the display 103, a contact list screen 1036 such as shown in Fig. 22 when the operator selected "list".

For a contact pair determined to have penetration occurring therein as a result of an interference check by the interference determination unit 12, or a contact pair determined to have a zero degree normal angle in the calculation result of the normal angle by the normal angle calculation unit 13, that is, for a contact pair having a flag indicating an error set in array CONTACT 21, the contact list screen 1036 shown in Fig. 22 presents the pair number in association with errors, the group number, the number of surface 1, the number of surface 2, the name of surface 1 and the name of surface 2.

The contact list screen 1036, showing the content of array CONTACT 21, presents a contact group number as the group number, a contact pair number as the pair number, a master surface group number as the number of surface 1, a slave surface group number as the number of surface 2, a master surface group name as the name of surface 1 and a slave surface group name as the name of surface 2, respectively.

Now, in the contact list screen 1036 displayed on the display 103, the display control unit 15 is configured to present, on the display 103, an error detail screen 1037 such as shown in Fig. 23, when the operator selected the error field, for example, by double-clicking it using the mouse 102.

The error detail screen 1037 for presenting the detail information with regard to all the nodes relating to interference, for the contact pairs shown in the contact list screen 1036, presents, in the example shown in Fig. 23, node numbers in association with the number of surface group 1, the number of surface group 2, the number of contact surface 2, distance, the normal 1, the normal 2 and the normal angle.

Here, in the example shown in Fig. 23, a master surface group number, in array CONNODE 22, is presented as the number of surface group 1, and likewise, a slave surface group number as the number of surface group 2, a master surface number as the number of contact surface 2, a slave node number as the node number; a normal direction (X), a normal direction (Y) and a normal direction (Z) of the master surface are presented as the normal 1; a normal direction (X), a normal direction (Y) and a normal direction (Z) of the slave surface are presented as the normal 2; and an angle is presented as the normal angle.

In other words, the display control unit 15 functions as a notification unit for notifying the operator of the information with regard to the normal angle calculated by the normal angle calculation unit 13, or the information with regard to the interference check result performed by the interference determination unit 12, presenting the contact list screen 1036 and the error detail screen 1037 on the display 103.

Here, the information with regard to the normal angle to be notified to the operator may be the normal angle itself such as stated above, or alternatively, the CPU 100 may, for example determine (in a determination step) whether or not the normal angle satisfies a predefined condition (180 degrees, or not), and notify (in a notification step) the operator of the determination result.

Similarly, the information with regard to the interference check result to be notified to the operator may be the distance itself between the nodes such as stated above, or alternatively, the CPU 100 may, for example determine (in a determination step) whether or not the distance between the nodes satisfies a predefined condition (equal to or above 0, or not), and notify (in a notification step) the operator of the determination result.

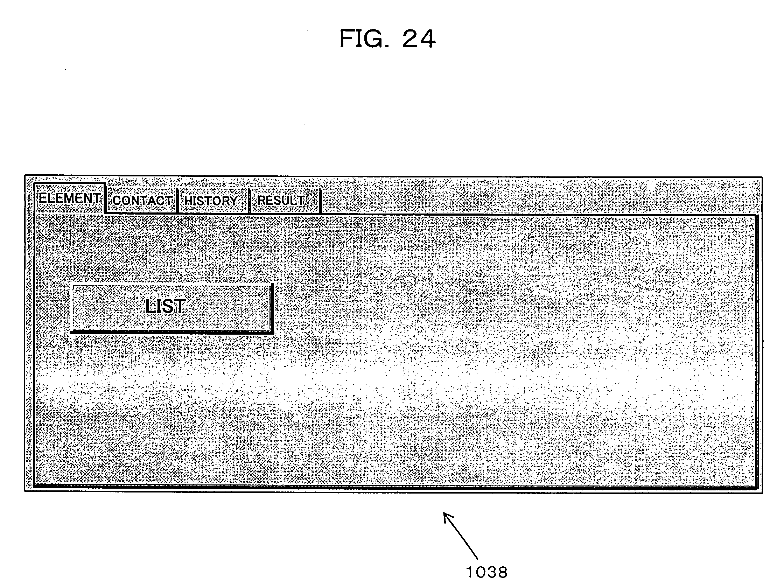

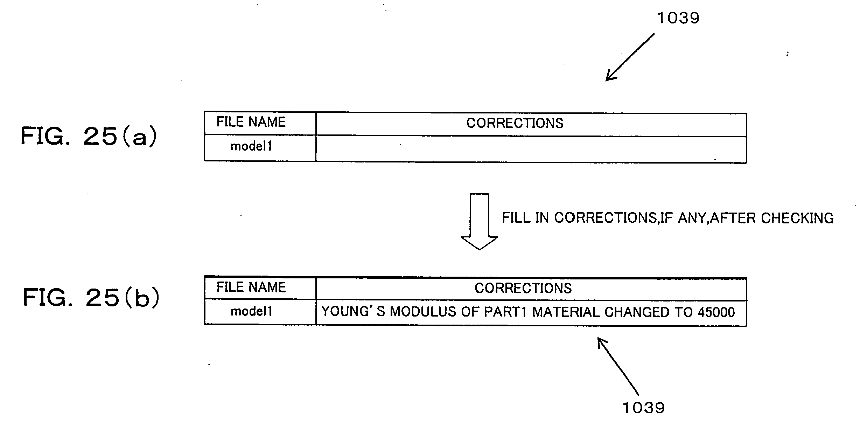

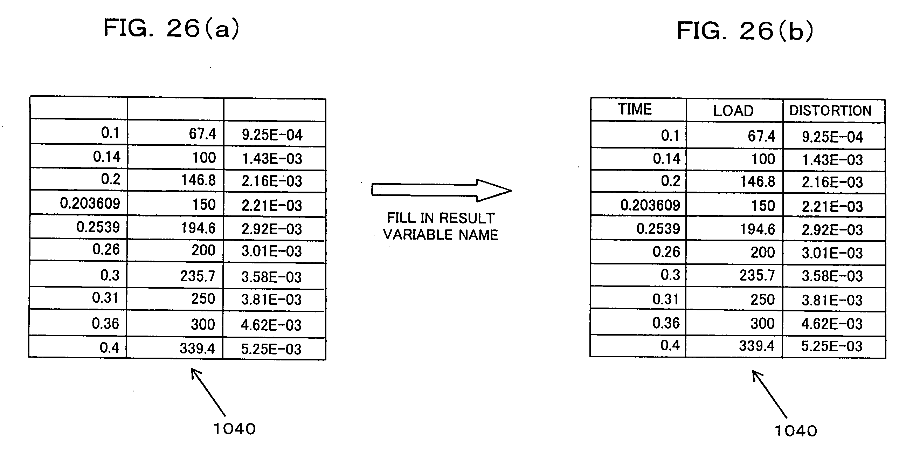

In addition, Fig. 24 is a diagram showing an exemplary history screen 1038 for entering instructions to present the information with regard to the history to be displayed on the display 103 of the numerical simulation system 1 as an embodiment of the present invention; Figs. 25(a) and (b) are diagrams showing an exemplary history list screen respectively; and Figs. 26(a) and (b) are diagrams showing an exemplary a result list presentation screen respectively.

The display control unit 15 is configured to present, on the display 103, a history screen 1038 such as shown in Fig. 24, and present, on the display 103, a history list screen 1039 such as shown in Figs. (a) and (b) when the operator selected "list".

The history list screen 1039 for presenting the information with regard to the history indicates the updating status of the file of the analysis model, and Fig. 25(b) shows the information about changing (correcting) the Young's modulus of the material of PART1 to 45,000 described in the changes field with regard to the data whose filename is model1 in the history list screen 1039 shown in Fig. 25 (a). Thus, the changes, whenever made by the operator, can be described as comments, thereby enhancing convenience and reliability of the data as well.

Young's modulus is corrected according to the flag "1" having been set to the check column of array ELEM 17 by selecting a check button 1034a in the element confirmation screen 1034 of Fig. 20, as stated above.

In addition, the numerical simulation system 1 is configured to acquire the analysis result by the solver 3 and manage the analysis result in a uniform manner.

Specifically, in the data reading screen 1031 shown in Fig. 5, the analysis result data is imported into the numerical simulation management device 10 by entering the filename of, as well as the path to, the result data of the analysis by the solver 3 into the FILE field and selecting the "read-in results" button. The imported analysis result data is stored in array RES 23.

The display control unit 15 is configured to also present, on the display 103, the analysis result by the solver 3 and present, on the display 103, the stored analysis result in array RES 23. In addition, the display control unit 15 can, in the process, comprehensibly present to the operator the analysis result 1040 as shown in Fig. 26 (b), by displaying on the display 103 the analysis result 1040 showing the content of array RES 23 such as shown in Fig. 26 (a) in association with the result variable name, referring to array RESV 24 (see Fig. 16).

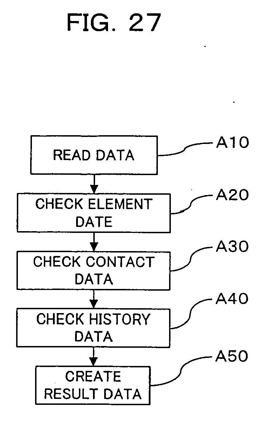

The general flow of the simulation in the numerical simulation system 1 as an embodiment of the present invention configured as stated above will be explained, referring to the flow chart (steps A10 to A50) shown in Fig. 27.

For example, the preprocessor 2 generates an analysis model based on the modeling data generated by a three-dimensional CAD. In the numerical simulation management device 10, the analysis model acquisition unit 26 reads data (step A10) of the analysis file generated by the preprocessor 2, checks element data (step A30), checks contact data (step A20), and checks historical data (step A40).

In the analysis model, the solver 3 is used for analyzing the analysis model when no errors were detected in the boundary condition check by the interference determination unit 12 and the normal angle calculation unit 13, or after the detected errors were removed by corrections or the like.

Then the numerical simulation management device 10 acquires the analysis result from the solver 3, generates result data of array RES 23 (step A50), and terminates the process.

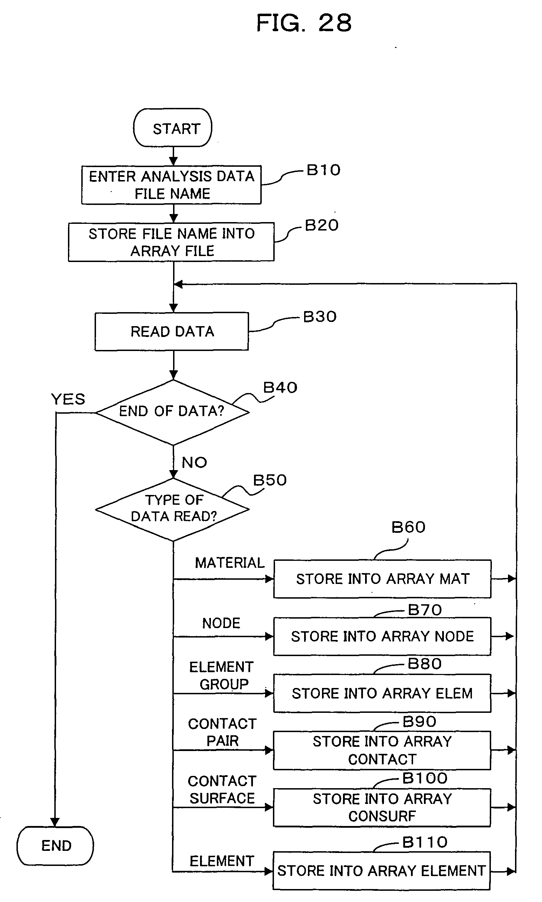

Next, the process with regard to acquisition of the analysis model data by the analysis model acquisition unit 26 in the numerical simulation system 1 as an embodiment of the present invention will be explained in the flow chart (steps B10 to B110) shown in Fig. 28.

Upon presentation of a data reading screen 1031, such as shown in Fig. 5, on the display 103 via the display control unit 15 by the analysis model acquisition unit 2 6, the operator starts inputting of the analysis model by entering the filename of the data of the analysis model in the data reading screen 1031 (step B10).

The data management unit 14 stores the analysis input filename in array FILE 16 (step B20) , and the analysis model acquisition unit 26 starts reading the data of the analysis model (step B30).

The data management unit 14 determines whether or not the reading of the data of the analysis model is finished (step B40), and, if not yet finished (see the NO route of step B40), subsequently determines the type of the read-in data (step B50).

If the read-in data relates to a material (see "material" route of step B50), the data is stored in array MAT 18 (step B60), and the process returns to step B40. Similarly, if the read-in data relates to a node (see "node" route of step B50), the data is stored in array NODE 19 (step B70), if the read-in data relates to an element group (see "element group" route of step B50), the data is stored in array ELEM 17 (step B80), if the read-in data relates to a contact pair (see " contact pair" route of step B50), the data is stored in array CONTACT 21 (step B90), if the read-in data relates to a contact surface (see "contact surface" route of step B50), the data is stored in array CONSURF 20 (step B100), and if the read-in data relates to an element (see "element" route of step B50), the data is stored in array ELEMENT 25 (step B110), respectively, and the process returns to step B40.

On the other hand, if there is no data left, the process terminates (see the YES route of step B40).

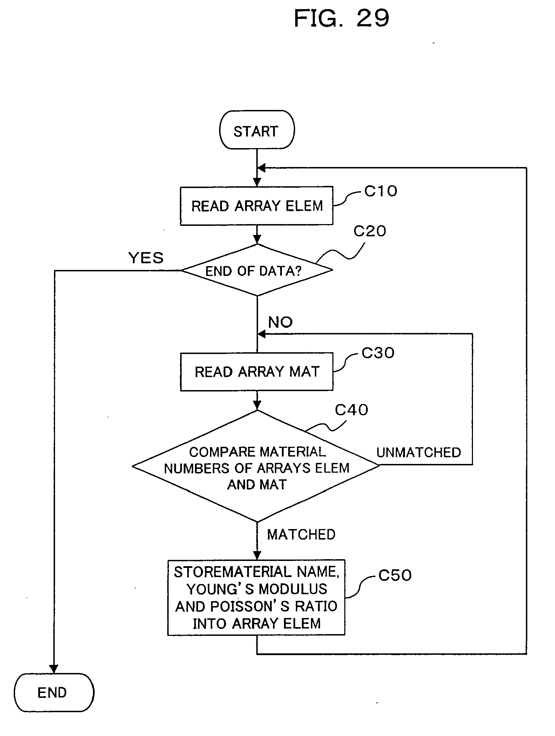

Next, the procedure of generating element group data in the numerical simulation system 1 as an embodiment of the present invention will be explained according to the flow chart (steps C10 to C50) shown in Fig. 29.

The data management unit 14 first reads array ELEM 17 (step C10) and determines whether or not the data reading is finished (step C20). If not all of the data in array ELEM 17 have been processed yet (see the NO route of step C20), the data management unit 14 reads array MAT 18 (step C30) and compares the material number in array ELEM 17 with the material number of array MAT 18 (step C40).

Here, if the material numbers matched (see matched route of step C40), the material name, Young's modulus and Poisson's ratio relating to the material number are acquired from array MAT 18 and stored in array ELEM 17 as the material name, Young's modulus and Poisson's ratio relating to the material number (step C50), then the process returns to step C10. In addition, if the material numbers do not match (see unmatched route of step C40), the process returns to step C 30.

On the other hand, if processing of all of the data in array ELEM 17 has been completed (see the YES route of step C20), the process terminates.

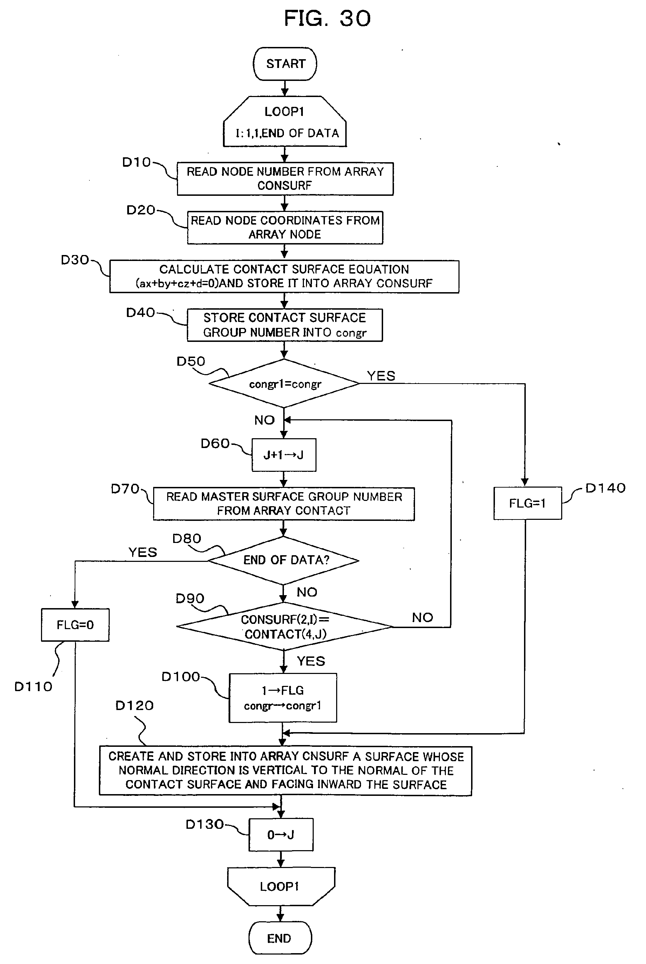

Next, the procedure of generating a contact surface and a perpendicular surface by the space determination unit 11 of the numerical simulation system 1 as an embodiment of the present invention will be explained according to the flow chart (steps D10 to D140) shown in Fig. 30.

The space determination unit 11 initializes (I = 1) variable I, reads a node number from the top data column of array CONSURF 20 sequentially (step D10), and reads the node coordinates of the node from array NODE 19 (step D20). In addition, the space determination unit 11 solves the equation of the contact surface (see equation (1) above), and stores the calculated coefficients a, b, c and d in array CONSURF 20 (step D30).

In addition, the space determination unit 11 acquires the contact surface group number from array CONSURF 20, and stores it in variable congr (step D40).

Then, the space determination unit 11 determines whether or not congr1 = congr holds (step D50), increments (J = J + 1) variable J (step D60) if congr1 does not coincide with congr (see the NO route of step D50), and subsequently reads the J-th master surface group number from the top of array CONACT 21 (step D70).

The space determination unit 11 determines whether or not all of the data in array CONTACT 21 have been processed (step D80) and, if not all of the data have been processed yet (see the NO route of step D0), subsequently determines whether or not the I-th value(CONSURF(2, I)) from the top of the contact surface group numbers in array CONSURF 20 matches the J-th value (CONTACT (4, J)) of the master surface group numbers in array CONTACT 21 (step D90). If they do not match (see the NO route of step D90), the process returns to step D60. If, on the other hand, they match (see the YES route of step D90), flag FLG is set to 1 and the variable congr1 is substituted by the value of congr (step D100).

The space determination unit 11 then generates, for each of the four edges composing the contact surface, an equation of a surface including each edge, having a normal perpendicular to the normal of the contact surface, and further having a normal direction facing inward of the check space, and store the perpendicular surface coefficients $a_1$, $a_2$, $a_3$, $a_4$, $b_1$, $b_2$, $b_3$, $b_4$, $C_1$, $C_2$, $C_3$, $C_4$, $d_1$, $d_2$, $d_3$ and $d_4$ composing these equations in array CONSURF 20 (step D120).

In addition, if all of the data have been processed (see the YES route of step D80), flag FLG is set to 0 (step D110), and subsequently, the space determination unit 11 sets J to 0 (step D130).

Here, if congr1 coincides with congr (see the YES route of step D50), flag FLG is set to 1 (step D140) and the process moves to step D120.

The space determination unit 11 repeats the process until the last data column of array CONSURF 20 is reached, and the process terminates is the last data column of array CONSURF 20 is reached.

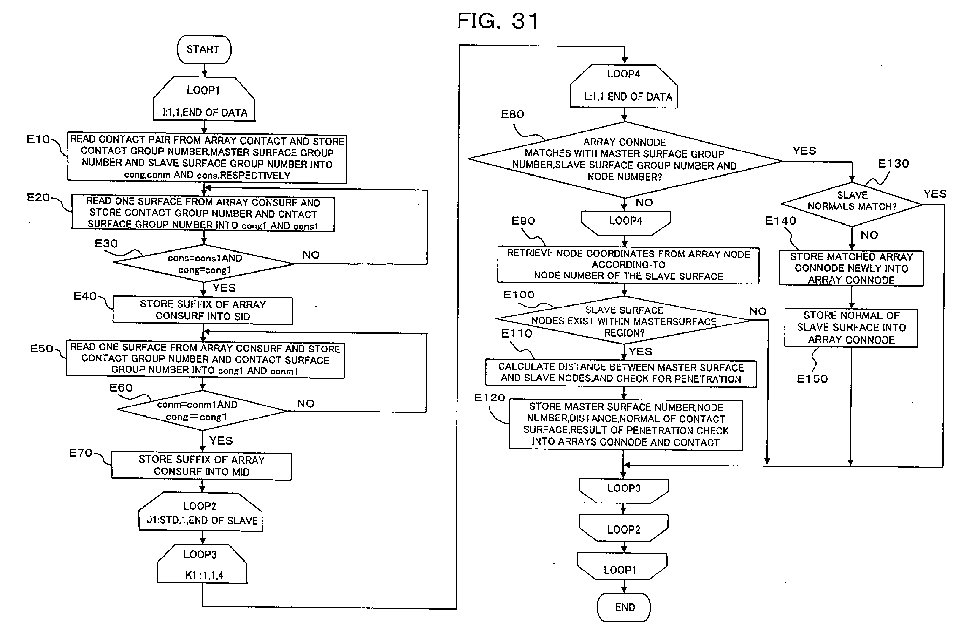

Next, the procedure of generating a contact-point-pair-contact-surface in the numerical simulation system 1 as an embodiment of the present invention will be explained according to the flow chart (steps E10 to E150) shown in Fig. 31.

The numerical simulation management device 10 initializes(I = 1) variable I, reads information relating to the contact pair from the top data column in array CONTACT 21 sequentially, and substitutes the contact group number, the master surface group number and the slave surface group number into variables cong, conm and cons, respectively (step E10).

The numerical simulation management device 10 subsequently reads one surface from array CONSURF 20, and substitutes the contact group number and the contact surface group number into variables cong1 and cons 1, respectively (step E20).

The numerical simulation management device 10 then determines whether or not both "cons = cons1" and "cong = cong1" holds (step E30). If both "cons = cons1" and "cong = cong1" does not hold (see the NO route of step E30), the process returns to step E20, and, if both "cons = cons1" and "cong = cong1" holds (see the YES route of step E30), the ordinal number (suffix) from the top of the data column in array CONSURF 20 is substituted into variable SID (step E40).

The numerical simulation management device 10 subsequently reads one surface from array CONSURF 20 and substitutes the contact group number and the contact surface group number into variables cong1 and conm1, respectively (step E50).

The numerical simulation management device 10 then determines whether or not "conm = conm1" and "cong = cong1" holds (step E60). If "conm = conm1" and "cong = cong1" does not hold (see the NO route of step E60), the process returns to step E50, and, if "conm = conm1" and "cong = cong1" holds (see the YES route of step E60), the ordinal number (suffix) from the top of the data column in array CONSURF 20 is substituted into variable MID (step E70).

Here, the numerical simulation management device 10 sets the value of SID as the initial value of variable J1, and value 1 is set to both variables K1 and L as the initial value.

The numerical simulation management device 10 then repeats comparing whether a master surface group number, a slave surface group number and a node number match those in array CONNODE 22 until there is no data left (step E80), and, if no match is detected (see the NO route of step E80), further acquires the node coordinates from array NODE 19 based on the node number of the slave surface (step E90).

Next, the space determination unit 11 determines (step E100) whether or not a node of the slave surface (slave node) exist within the check space (master surface region). If the node exists within the check space (see the YES route of step E100), the interference determination unit 12 calculates the distance between the master surface and the slave node, determines whether or not penetration is occurring (step E110), and stores the master surface number, the node number, the distance, the contact surface normal and the result of penetration check (error code) in arrays CONNODE 22 and CONTACT 21 (step E120).

In addition, if array CONNODE 22 matches the master surface group number, the slave surface group number and the node number (see the YES route of step E80), array CONNODE 22 is compared with the slave normal (step E130). If the slave normal does not match (see the NO route of step E130, array CONNODE 22 which matched in step E80 is stored as a new data column in array CONNODE 22 (step E140), and the slave surface normal is stored in array CONNODE 22 (step E150). On the other hand, if the slave normal matches array CONNODE 22 (see the YES route of step E130), the process returns to loop 3.

If the node does not exist in the check space (see the NO route of step E100), the space determination unit 11 repeats the above process of steps E80 to E150, incrementing K1 (K = K + 1), until K = 4 is reached, repeats the process of steps E80 to E150 for all of the slaves, incrementing J1 (J1 = J1 + 1), and further repeats the loop incrementing (L = L + 1) L until all of the data has been processed.

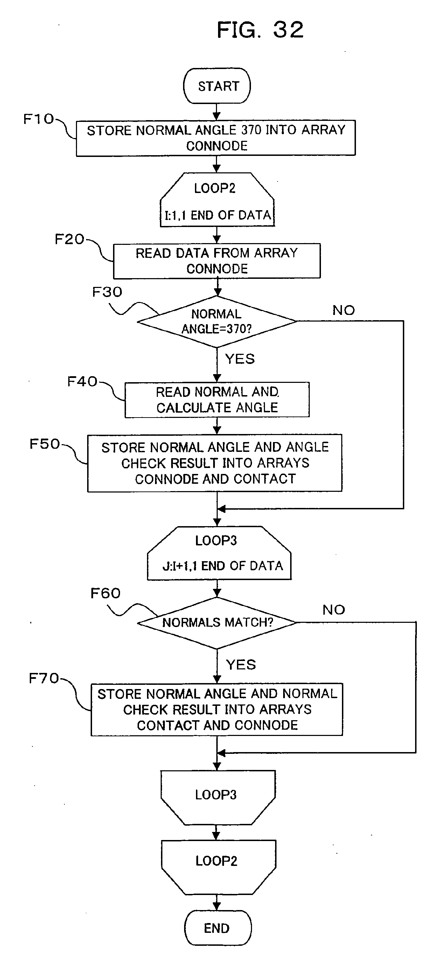

Next, the procedure of checking the normal direction by the normal angle calculation unit 13 in the numerical simulation system 1 as an embodiment of the present invention will be explained according to the flow chart (steps F10 to F70) shown in Fig. 32 next.

The normal angle calculation unit 13 stores a normal angle of 370 degrees as an initial value in all of the angle fields in array CONNODE 22 (step F10). Here, the initial value is not limited to 370 and any value will do except those in the range 0 to 360.

The normal angle calculation unit 13 initializes variable I by setting an initial value of 1, and reads data of an angle (normal angle) in array CONNODE 22 from its top data column (step F20).

The normal angle calculation unit 13 determines whether or not the acquired normal angle is 370 degrees (step F30), and calculates (step F40) the angle between the normal of the master surface and the normal of the slave surface if the normal angle is 370 degrees (see the YES route of step F30). Here, the angle formed by these normals can be calculated based on, for example, the outer product between the normal vector of the master surface and the normal vector of the slave surface.

The normal angle calculation unit 13 then stores the normal angle and the result of angle check in array CONNODE 22 and array CONTACT 21 (step F50).

Next, the normal angle calculation unit 13 sets an initial value I + 1 in variable J, determines whether or not the normal direction of the master surface matches the normal direction of the slave surface (step F60), and, if they match (see the YES route of step F60), stores the normal angle and the result of normal check in array CONTACT 21 and array CONNODE 22 as an error code (step F70).

Here, if the a normal angle is not 370 degrees (the NO route of step F30), an initial value I + 1 is set to variable J and the process moves to step F60, whereas the process of the above-mentioned steps F20 to F70 is repeated until there is no data left, if the normal directions do not match (see the NO route of step F60).

In the numerical simulation system 1, array MAT 18, array NODE 19, array CONSURF 20, array CONTACT 21 and array ELEMENT 25, having a three-dimensional array structure, can check the updating of the history data between a pre-update data set (existing data) and a post-update data (new data) by the procedure shown in the following.

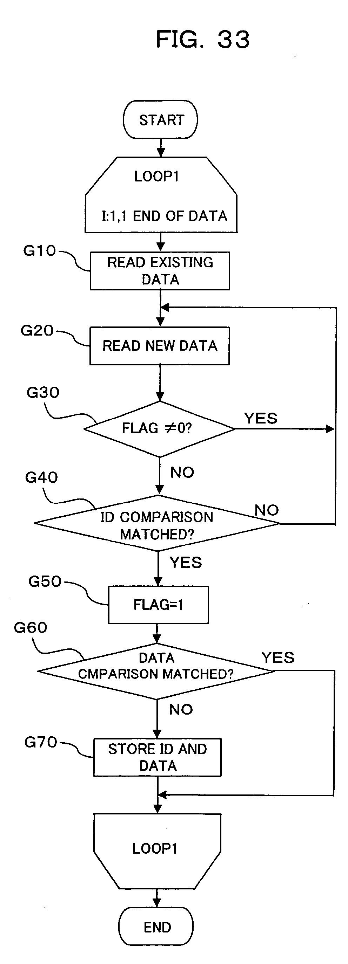

The procedure of checking the changes to the historical data in the numerical simulation system 1 as an embodiment of the present invention will be explained according to the flow chart (steps G10 to G70) shown in Fig. 33.

The numerical simulation management device 10 first sets an initial value 1 to variable I, reads existing data (step G10), and also reads new data (step G20).

The numerical simulation management device 10 then determines whether or not the flag is non-zero(step G30), and the process returns to step G20 if the flag is non-zero (see the YES route of step G30). If the flag is zero (see the NO route of step G30), the numerical simulationmanagement device 10 compares the IDs of the new data and the old data (step G40), and the process returns to step G20 if the IDs do not match (see the NO route of step G40).

Here, an ID is, for example, the "material number" in array MAT 18, the "node number" in array NODE 19, the "contact group number" in array CONSURF 20, or the "contact group number" and the "contact pair number" in array CONTACT 21, wherein a number which is convenient for identification corresponds to an item to be registered as the data.

If the IDs match (see the YES route of step G40), the numerical simulation management device 10 sets the flag to 1 (step G50), and compares the data (step G60). Then, if the data match (see the YES route of step G60), the process proceeds to the next data. If the data do not match (see the NO route of step G60), the numerical simulation management device 10 stores the ID and the data (step G70) as the history data of changes before proceeding to the next data, and subsequently, repeats the above process of steps G10 to G70 for all of the data.

As thus described, according to the numerical simulation system 1 as an embodiment of the present invention, since the space determination unit 11 determines whether or not the slave nodes composing the slave surface are included in the check space formed by projecting the master surface among the two surfaces forming the contact pair to its normal direction, and, if the slave nodes are determined to exist in check space, the interference determination unit 12 calculates the distance between the master surface and the slave nodes and determines that interference is occurring if the distance is smaller than zero, boundary condition can be checked in the analysis model before executing analysis by the solver 3, thereby reducing design time as well as facilitating early detection of mistakes and cutting man-hours.

In addition, since the normal angle calculation unit 13 calculates the normal angle formed by the normals of the master surface and slave surface based on the normal directions of the master surface and the slave surface of among the two surfaces forming the contact pair, boundary condition can be checked in the analysis model before executing analysis by the solver 3, thereby reducing design time as well as facilitating early detection of mistakes and cutting man-hours.

Furthermore, since array MAT 18, array NODE 19, array CONSURF 20, array CONTACT 21 and array ELEMENT 25 compose a matrix-like data set by preparing a plurality of data columns wherein data items of multiple types are associated with each other, which is then arranged as a three-dimensionally arrayed data group (three-dimensional array structure) by preparing a plurality of the data set, data of multiple types can be managed in a uniform manner, as well as facilitating comparison of respective data, and particularly, by placing the history of each data composing the data set in time series along the r-axis, the data set before the change (original data) and the data set after the change (new data) can be readily compared and the difference between the original data and the new data can be automatically recognized, thereby facilitating unified management of the historical data.

In addition, since array ELEM 17 has, in association with element group numbers and element group names, the information relating to the material such as the material name, Young's modulus and Poisson's ratio, the operator can readily and quickly retrieve information with regard to the material only by referring to array ELEM 17, with enhanced convenience. In other words, necessary information is immediately recognizable by managing and checking the necessary information of the analysis data thereby facilitating early detection of mistakes and cutting man-hours.

For example, the prior art analysis in designing a cellular phone commonly takes a week to 10 days, wherein correction is repeated about three times during the process frompreparing the analysis input file to obtaining the result. Using the numerical simulation system 1 of the present invention cuts the correction man-hour (doing over), whereby the result can be obtained in about three days after preparing the analysis input file.

The operator can check the data with enhanced convenience by presenting the result of interference check by the interference determination unit 12 or the calculation result of the normal angle by the normal angle calculation unit 13, in a list form as shown in Fig. 22 and Fig. 23 on the display 103, or by presenting one by one.

The present invention is not limited to the above-mentioned embodiments and can be implemented in various variations which do not deviate from the scope of the present invention.

For example, although the preprocessor 2, the solver 3 and the post processor 4 are shown, as in Fig. 1, separately from the numerical simulation management device 10 in the above-mentioned embodiments, at least some parts of the preprocessor 2, the solver 3 and the post processor 4 may be implemented by the same computer as with the numerical simulation device 10, or, at least two among the preprocessor 2, the solver 3 and the post processor 4 may be implemented by the same computer.

Additionally, although an example is shown which verifies the boundary condition (contact condition) in a structure analysis using finite element method in the above-mentioned embodiments, the present invention is by no means limited to this, and may be applied to, for example, definition check of a radiation surface in thermal conductivity analysis, or check on the boundary defined in a surface in boundary element method analysis.

Additionally, the present inventionmaybe implemented and manufactured by one of ordinary skill in the art, provided that the embodiments of the present invention are disclosed.

For example, the present invention may be applied to definition check of a radiation surface in thermal conductivity analysis, or check on the boundary defined in a surface in boundary element method analysis.

**Claims**

1. A numerical analysis aiding device for verifying a boundary condition between surfaces forming a pair associated with each element in an analysis model comprising a component which is element-partitioned into two or more elements, for two of said elements having a boundary condition defined between two surfaces, said device comprising:

a space determination unit (11) for determining, with regard to a master surface to be verified among said two surfaces forming the pair, whether or not given slave nodes composing a slave surface other than said master surface among said two surfaces forming the pair are included in a check space formed by projecting said master surface to its normal direction; and

an interference determination unit (12) for calculating the distance between said master surface and said slave surface if said slave nodes are determined to exist in said check space according to the determination of said space determination unit, and determining that interference is occurring if said distance is smaller than zero.

2. A numerical analysis aiding device for verifying a boundary condition between surfaces forming a pair associated with each element in an analysis model comprising a component which is element-partitioned into two or more elements, for two of said elements having a boundary condition defined between two surfaces, said device comprising:

a normal angle calculation unit (13) for calculating a normal angle formed by the normal of a master surface to be verified among said two surfaces forming the pair and the normal of a slave surface other than said master surface among said two surfaces forming the pair, based on the normal directions of said master surface and said slave surface, respectively.

3. A numerical analysis aiding device for verifying a boundary condition between surfaces forming a pair associated with each element in an analysis model comprising a component which is element-partitioned into two or more elements, for two of said elements having a boundary condition defined between two surfaces, said device comprising:

a space determination unit (11) for determining, with regard to a master surface to be verified among said two surfaces forming the pair, whether or not given slave nodes composing a slave surface other than said master surface among said two surfaces forming the pair are included in a check space formed by projecting said master surface to its normal direction;

an interference determination unit (12) for calculating the distance between said master surface and said slave surface if said slave nodes are determined to exist in said check space according to the determination of said space determination unit, and determining that interference is occurring if said distance is smaller than zero; and

a normal angle calculation unit (13) for calculating a normal angle formed by the normal of said master surface and the normal of said slave surface, based on the normal directions of said master surface and said slave surface, respectively.

4. A numerical analysis aiding device for verifying a boundary condition between surfaces formingapairassociated with each element in an analysis model comprising a component which is element-partitioned into two or more elements, for two of said elements having a boundary condition defined between two surfaces, said device comprising:

a data management unit (14) for arranging a matrix-like data set by preparing a plurality of data columns wherein data items of multiple types are associated with each other, arranging a three-dimensionally arrayed data group by preparing a plurality of said data set, and managing information with regard to said elements.

5. The numerical analysis aiding device according to any one of claims 1 to 3 comprising a data management unit (14) for arranging a matrix-like data set by preparing a plurality of data columns wherein data items of multiple types are associated with each other, arranging a three-dimensionally arrayed data group by preparing a plurality of said data set, and managing information with regard to said elements.

6. A numerical analysis aiding method for verifying a boundary condition between surfaces forming a pair associated with each element in an analysis model comprising a component which is element-partitioned into two or more elements, for two of said elements having a boundary condition defined between two surfaces, said method comprising:

a space determination step for determining, with regard to a master surface to be verified among said two surfaces forming the pair, whether or not given slave nodes composing a slave surface other than said master surface among said two surfaces forming the pair are included in a check space formed by projecting said master surface to its normal direction; and

an interference determination step for calculating, if said slave nodes are determined to exist in said check space according to the determination of said space determination step, the distance between said master surface and said slave surface, and determining that interference is occurring if said distance is smaller than zero.

7. A numerical analysis aiding method for verifying a boundary condition between surfaces forming a pair associated with each element in an analysis model comprising a component which is element-partitioned into two or more elements, for two of said elements having a boundary condition defined between two surfaces, said method comprising:

a normal angle calculation step for calculating, based on the normal direction of a master surface to be verified among said two surfaces forming the pair and the normal direction of a slave surface other than said master surface among said two surfaces forming the pair, the normal angle formed by the normal of said master surface and the normal of said slave surface; and
a notification step for notifying information with regard to said angle calculated in said normal angle calculation step.

8. A numerical analysis aiding method for verifying a boundary condition between surfaces forming a pair associated with each element in an analysis model comprising a component which is element-partitioned into two or more elements, for two of said elements having a boundary condition defined between two surfaces, said method comprising:

a space determination step for determining, with regard to a master surface to be verified among said two surfaces forming the pair, whether or not given slave nodes composing a slave surface other than said master surface among said two surfaces forming the pair are included in a check space formed by projecting said master surface to its normal direction;
an interference determination step for calculating, if said slave nodes are determined to exist in said check space according to the determination of said space determination step, the distance between said master surface and said slave surface, and determining that interference is occurring if said distance is smaller than zero; and
a normal angle calculation step for calculating a normal angle formed by the normal of said master surface and the normal of said slave surface, based on the normal directions of said master surface and said slave surface, respectively.

9. A numerical analysis aiding program for instructing a computer to perform a numerical analysis aiding function for verifying a boundary condition between surfaces forming a pair associated with each element in an analysis model comprising a component which is element-partitioned into two or more elements, for two of said elements having a boundary condition defined between two surfaces, wherein said numerical analysis aiding program instructs said computer to function as:

a space determination unit (11) for determining, with regard to a master surface to be verified among said two surfaces forming the pair, whether or not given slave nodes composing a slave surface other than said master surface among said two surfaces forming the pair are included in a check space formed by projecting said master surface to its normal direction; and
an interference determination unit (12) for calculating the distance between said master surface and said slave surface if said slave nodes are determined to exist in said check space according to the determination of said space determination unit, and determining that interference is occurring if said distance is smaller than zero.

10. A numerical analysis aiding program for instructing a computer to perform a numerical analysis aiding function for verifying a boundary condition between surfaces forming a pair associated with each element in an analysis model comprising a component which is element-partitioned into two ormore elements, for two of said elements having a boundary condition defined between two surfaces, wherein said numerical analysis aiding program instructs said computer to function as:

a normal angle calculation unit (13) for calculating a normal angle formed by the normal of a master surface to be verified among said two surfaces forming the pair and the normal of a slave surface other than said master surface among said two surfaces forming the pair, based on the normal directions of said master surface and said slave surface, respectively.

**11.** A numerical analysis aiding program for instructing a computer to perform a numerical analysis aiding function for verifying a boundary condition between surfaces forming a pair associated with each element in an analysis model comprising a component which is element-partitioned into two or more elements , for two of said elements having a boundary condition defined between two surfaces, wherein said numerical analysis aiding program instructs said computer to function as:

a space determination unit (11) for determining, with regard to a master surface to be verified among said two surfaces forming the pair, whether or not given slave nodes composing a slave surface other than said master surface among said two surfaces forming the pair are included in a check space formed by projecting said master surface to its normal direction;

an interference determination unit (12) for calculating the distance between said master surface and said slave surface if said slave nodes are determined to exist in said check space according to the determination of said space determination unit, and determining that interference is occurring if said distance is smaller than zero; and

a normal angle calculation unit (13) for calculating a normal angle formed by the normal of said master surface and the normal of said slave surface, based on the normal directions of said master surface and said slave surface, respectively.

**12.** A numerical analysis aiding program for instructing a computer to perform a numerical analysis aiding function for verifying a boundary condition between surfaces forming a pair associated with each element in an analysis model comprising a component which is element-partitioned into two or more elements, for two of said elements having a boundary condition defined between two surfaces, wherein said numerical analysis aiding program instructs said computer to function as:

a data management unit (14) for arranging a matrix-like data set by preparing a plurality of data columns wherein data items of multiple types are associated with each other, arranging a three-dimensionally arrayed data group by preparing a plurality of said data set, and managing information with regard to said elements.

**13.** The numerical analysis aiding program according to any one of claims 9 to 11 instructs the computer to function as a data management unit (14) for arranging a matrix-like data set by preparing a plurality of data columns wherein data items of multiple types are associated with each other, arranging a three-dimensionally arrayed data group by preparing a plurality of said data set, and managing information with regard to said elements.

**14.** A computer readable recordingmediumhaving a numerical analysis aiding program recorded thereon for instructing a computer to perform a numerical analysis aiding function for verifying a boundary condition between surfaces forming a pair associated with each element in an analysis model comprising a component which is element-partitioned into two or more elements, for two of said elements having a boundary condition defined between two surfaces, wherein said numerical analysis aiding program instructs said computer to function as:

a space determination unit (11) for determining, with regard to a master surface to be verified among said two surfaces forming the pair, whether or not given slave nodes composing a slave surface other than said master surface among said two surfaces forming the pair are included in a check space formed by projecting said master surface to its normal direction; and

an interference determination unit (12) for calculating the distance between said master surface and said slave surface if said slave nodes are determined to exist in said check space according to the determination of said space determination unit, and determining that interference is occurring if said distance is smaller than zero.

**15.** Acomputer readable recording medium having a numerical analysis aiding program recorded thereon for instructing a computer to perform a numerical analysis aiding function for verifying, in an analysis model comprising a component which is element-partitioned into two or more elements with two of said elements having a boundary condition defined between two surfaces, the boundary condition between the surfaces forming a pair associated with respective elements, wherein said numerical analysis aiding program instructs said computer to function as:

a normal angle calculation unit (13) for calculating a normal angle formed by the normal of a master surface to be verified among said two surfaces forming the pair and the normal of a slave surface other than said master surface among said two surfaces forming the pair, based on the normal directions of said master surface and said slave surface, respectively.

**16.** A computer readable recordingmediumhaving a numerical analysis aiding program recorded thereon for instructing a computer to perform a numerical analysis aiding function for verifying a boundary condition between surfaces forming a pair associated with each element in an analysis model comprising a component which is element-partitioned into two or more elements, for two of said elements having a boundary condition defined between two surfaces, wherein said numerical analysis aiding program instructs said computer to function as:

a space determination unit (11) for determining, with regard to a master surface to be verified among said two surfaces forming the pair, whether or not given slave nodes composing a slave surface other than said master surface among said two surfaces forming the pair are included in a check space formed by projecting said master surface to its normal direction;

an interference determination unit (12) for calculating the distance between said master surface and said slave surface if said slave nodes are determined to exist in said check space according to the determination of said space determination unit, and determining that interference is occurring if said distance is smaller than zero; and

a normal angle calculation unit (13) for calculating a normal angle formed by the normal of said master surface and the normal of said slave surface, based on the normal directions of said master surface and said slave surface, respectively.

17. A computer readable recordingmediumhaving a numerical analysis aiding program recorded thereon for instructing a computer to perform a numerical analysis aiding function for verifying a boundary condition between surfaces forming a pair associated with each element in an analysis model comprising a component which is element-partitioned into two or more elements, for two of said elements having a boundary condition defined between two surfaces, wherein said numerical analysis aiding program instructs said computer to function as:

a data management unit (14) for arranging a matrix-like data set by preparing a plurality of data columns wherein data items of multiple types are associated with each other, arranging a three-dimensionally arrayed data group by preparing a plurality of said data set, and managing information with regard to said elements.

18. The computer readable recording medium according to any one of claims 14 to 16 having a numerical analysis aiding program recorded thereon for instructing a computer to function as a data management unit (14) for arranging a matrix-like data set by preparing a plurality of data columns wherein data items of multiple types are associated with each other, arranging a three-dimensionally arrayed data group by preparing a plurality of said data set, and managing information with regard to said elements.

# FIG. 1

MODELING DATA → **2** PREPROCE-SSOR

ANALYSIS MODEL →

KEYBOARD

102: MOUSE

103: DISPLAY

1: NUMERICAL SIMULATION SYSTEM

**100: CPU**

| ANALYSIS MODEL ACQUISITION | 26 |
| SPACE DETERMINATION UNIT | 11 |
| INTERFERENCE DETERMINATION UNIT | 12 |
| NORMAL ANGLE CALCULATION UNIT | 13 |
| DATA MANAGEMENT UNIT | 14 |
| DISPLAY CONTROL UNIT | 15 |

10: NUMERICAL SIMULATION MANAGEMENT DEVICE

**3** SOLVER → **4** POST PROCESSOR

**104: HARD DISK**

ARRAY FILE — 16
ARRAY ELEM — 17
ARRAY MAT — 18
ARRAY NODE — 19
ARRAY CONSURF — 20
ARRAY CONTACT — 21
ARRAY CONNODE — 22
ARRAY RES — 23
ARRAY RESV — 24
ARRAY ELEMENT — 25

FIG. 2

PART3 MATERIAL NAME SUS
YOUNG'S MODULUS 2000000,
POISSON'S RATIO 0.3

PART1 MATERIAL NAME MG
YOUNG'S MODULUS
45000,POISSON'S RATIO 0.3

PART2 MATERIAL NAME SUS
YOUNG'S MODULUS 2000000,
POISSON'S RATIO 0.3

EP 1 677 220 A2

## FIG. 3

CONTACT SURFACE:
con_part3

CONTACT SURFACE:
con_part1_2

CONTACT SURFACE:
con_part1_1

CONTACT SURFACE:
con_part2

CONTACT SURFACE:
con_part2

EP 1 677 220 A2

FIG. 4

FIG. 5

DATA | ELEMENT | CONTACT | HISTORY | RESULT |

FILE: model1.in

MODEL READING

RESULT READING

1031

# FIG. 6

$a_4x + b_4y + c_4z + d_4 = 0$

SLAVE SURFACE

$a_3x + b_3y + c_3z + d_3 = 0$

NORMAL

$a_2x + b_2y + c_2z + d_2 = 0$

D

C

$a_1x + b_1y + c_1z + d_1 = 0$

A

B

MASTER SURFACE $ax + by + cz + d = 0$

# FIG. 7

|   | 1 | 2 |
|---|---|---|
| 1 | FILE NAME 1 | CHANGES |
| ⟨ |  |  |
| 50 |  |  |

16

# FIG. 8

| | CHECK | ELEMENT GROUP NUMBER | ELEMENT GROUP NAME | MATERIAL NUMBER | MATERIAL NAME | YOUNG'S MODULUS | POISSON'S RATIO | COMMENTS |
|---|---|---|---|---|---|---|---|---|
| | | | | | | | | |
| | | | | | | | | |

17

EP 1 677 220 A2

# FIG. 9

| 1 | 2 | 3 | 4 | 5 |
|---|---|---|---|---|
| MATERIAL NUMBER | MATERIAL NAME | YOUNG'S MODULUS | POISSON'S RATIO | FLAG |

FIG. 10

r

p

q

FIG. 11

EP 1 677 220 A2

FIG. 12

EP 1 677 220 A2

FIG. 12

| 1 | 2 | 3 | 4 | ~ | 7 | 8 | 9 | 10 | 11 | 12 | 13 | 14 | 15 |
|---|---|---|---|---|---|---|---|---|---|---|---|---|---|
| CONTACT GROUP NUMBER | CONTACT SURFACE GROUP NUMBER | CONTACT SURFACE NUMBER | NODE NUMBER | | NODE NUMBER | CONTACT SURFACE COEFFICIENT a | CONTACT SURFACE COEFFICIENT b | CONTACT SURFACE COEFFICIENT c | CONTACT SURFACE COEFFICIENT d | VERTICAL SURFACE COEFFICIENT a1 | VERTICAL SURFACE COEFFICIENT a2 | VERTICAL SURFACE COEFFICIENT a3 | VERTICAL SURFACE COEFFICIENT a4 |

| 16 | 17 | 18 | 19 | 20 | 21 | 22 | 23 | 24 | 25 | 26 | 27 | 28 |
|---|---|---|---|---|---|---|---|---|---|---|---|---|
| CONTACT SURFACE COEFFICIENT b1 | CONTACT SURFACE COEFFICIENT b2 | CONTACT SURFACE COEFFICIENT b3 | CONTACT SURFACE COEFFICIENT b4 | VERTICAL SURFACE COEFFICIENT c1 | VERTICAL SURFACE COEFFICIENT c2 | CONTACT SURFACE COEFFICIENT c3 | CONTACT SURFACE COEFFICIENT c4 | CONTACT SURFACE COEFFICIENT d1 | CONTACT SURFACE COEFFICIENT d2 | VERTICAL SURFACE COEFFICIENT d3 | VERTICAL SURFACE COEFFICIENT d4 | FLAG |

## FIG. 13

| ERROR | CONTACT GROUP NUMBER | CONTACT PAIR NUMBER | MASTER SURFACE GROUP NUMBER | SLAVE SURFACE GROUP NUMBER | MASTER SURFACE GROUP NAME | SLAVE SURFACE GROUP NAME | COMM-ENTS | FLAG |
|---|---|---|---|---|---|---|---|---|

EP 1 677 220 A2

## FIG. 14

| | 1 | 2 | 3 | 4 | 5 | 6 | 7 | 8 | 9 | 10 | 11 | 12 | 13 |
|---|---|---|---|---|---|---|---|---|---|---|---|---|---|
| 1 | MASTER SURFACE GROUP NUMBER | SLAVE SURFACE GROUP NUMBER | MASTER SURFACE NUMBER | SLAVE NODE NUMBER | DISTANCE | NORMAL DIRECTION OF MASTER SURFACE(X) | NORMAL DIRECTION OF MASTER SURFACE(Y) | NORMAL DIRECTION OF MASTER SURFACE(Z) | NORMAL DIRECTION OF SLAVE SURFACE(X) | NORMAL DIRECTION OF SLAVE SURFACE(Y) | NORMAL DIRECTION OF SLAVE SURFACE(Z) | ANGLE | ERROR |
| ⟩ | | | | | | | | | | | | | |
| 100 | | | | | | | | | | | | | |

22

# FIG. 15

|  | 1 | 2 | 3 | ~ | 100 |
|---|---|---|---|---|---|
| 1 | TIME STEP | RESULT | RESULT | · | RESULT |
| ∫ |  |  |  |  |  |
| 100 |  |  |  |  |  |

23

# FIG. 16

| | 1 | 2 | ~ | 100 |
|---|---|---|---|---|
| 1 | RESULT VARIABLE NAME | RESULT VARIABLE NAME | | RESULT VARIABLE NAME |

24

# FIG. 17

# FIG. 18

| DATA | ELEMENT | CONTACT | HISTORY | RESULT |

LIST

CINFIRM

1032

# FIG. 19

| CHECK | ELEMENT GROUP NUMBER | NAME | MATERIAL NUMBER | MATERIAL NAME | YOUNG'S MODULUS | POISSON'S RATIO | COMMENTS |
|---|---|---|---|---|---|---|---|
| 0 | 1 | part1 | 1 | MG | 45000 | 0.3 | |
| 0 | 2 | part2 | 2 | SUS | 200000 | 0.3 | |
| 0 | 3 | part3 | 2 | SUS | 200000 | 0.3 | |

1033

# FIG. 20

ELEMENT: 1(PART1)
MATERIAL: 1(MG)

YOUNG'S MODULUS=40000
POISSON'S RATIO=0.3

1034a

CHECK

BACK          OK          NEXT

1034

# FIG. 21

DATA | ELEMENT | CONTACT | HISTORY | RESULT

LIST

1035

EP 1 677 220 A2

# FIG. 22

| ERROR | GROUP NUMBER | PAIR NUMBER | SURFACE 1 NUMBER | SURFACE 2 NUMBER | SURFACE 1 NAME | SURFACE 2 NAME |
|---|---|---|---|---|---|---|
| 11 | 1 | 1 | 1 | 2 | con_part3 | con_part1_1 |
| 01 | 2 | 2 | 3 | 4 | con_part2 | con_part1_2 |

1036

EP 1 677 220 A2

# FIG. 23

| SURFACE GROUP NUMBER 1 | SURFACE GROUP NUMBER 2 | NODE NUMBER | CONTACT SURFACE NUMBER 2 | DISTANCE | NORMAL 1 | NORMAL 2 | NORMAL ANGLE |
|---|---|---|---|---|---|---|---|
| 1 | 2 | 76 | 1 | −5.4 | (0,0,1) | (0,0,1) | 0 |
| 1 | 2 | 97 | 3 | −5.4 | (0,0,1) | (0,0,1) | 0 |
| 3 | 4 | 11 | 1 | −0.5 | (0,0,1) | (0,0,−1) | 180 |
| 3 | 4 | 46 | 2 | −0.5 | (0,0,1) | (0,0,−1) | 180 |
| 3 | 4 | 42 | 3 | −0.5 | (0,0,1) | (0,0,−1) | 180 |
| 3 | 4 | 53 | 4 | −0.5 | (0,0,1) | (0,0,−1) | 180 |
| 3 | 4 | 51 | 5 | −0.5 | (0,0,1) | (0,0,−1) | 180 |
| 3 | 4 | 34 | 6 | −0.5 | (0,0,1) | (0,0,−1) | 180 |
| 3 | 4 | 19 | 8 | −0.5 | (0,0,1) | (0,0,−1) | 180 |
| 3 | 4 | 60 | 9 | −0.5 | (0,0,1) | (0,0,−1) | 180 |
| 3 | 4 | 55 | 10 | −0.5 | (0,0,1) | (0,0,−1) | 180 |
| 3 | 4 | 66 | 11 | −0.5 | (0,0,1) | (0,0,−1) | 180 |
| 3 | 4 | 65 | 12 | −0.5 | (0,0,1) | (0,0,−1) | 180 |
| 3 | 4 | 26 | 13 | −0.5 | (0,0,1) | (0,0,−1) | 180 |

1037

EP 1 677 220 A2

FIG. 24

EP 1 677 220 A2

| ELEMENT | CONTACT | HISTORY | RESULT |

LIST

1038

FIG. 25(a)

1039

| FILE NAME | CORRECTIONS |
|-----------|-------------|
| model1 | |

FILL IN CORRECTIONS,IF ANY,AFTER CHECKING

FIG. 25(b)

| FILE NAME | CORRECTIONS |
|-----------|-------------|
| model1 | YOUNG' S MODULUS OF PART1 MATERIAL CHANGED TO 45000 |

1039

EP 1 677 220 A2

## FIG. 26(a)

| | | |
|---:|---:|---:|
| 0.1 | 67.4 | 9.25E-04 |
| 0.14 | 100 | 1.43E-03 |
| 0.2 | 146.8 | 2.16E-03 |
| 0.203609 | 150 | 2.21E-03 |
| 0.2539 | 194.6 | 2.92E-03 |
| 0.26 | 200 | 3.01E-03 |
| 0.3 | 235.7 | 3.58E-03 |
| 0.31 | 250 | 3.81E-03 |
| 0.36 | 300 | 4.62E-03 |
| 0.4 | 339.4 | 5.25E-03 |

1040

FILL IN RESULT
VARIABLE NAME

## FIG. 26(b)

| TIME | LOAD | DISTORTION |
|---:|---:|---:|
| 0.1 | 67.4 | 9.25E-04 |
| 0.14 | 100 | 1.43E-03 |
| 0.2 | 146.8 | 2.16E-03 |
| 0.203609 | 150 | 2.21E-03 |
| 0.2539 | 194.6 | 2.92E-03 |
| 0.26 | 200 | 3.01E-03 |
| 0.3 | 235.7 | 3.58E-03 |
| 0.31 | 250 | 3.81E-03 |
| 0.36 | 300 | 4.62E-03 |
| 0.4 | 339.4 | 5.25E-03 |

1040

EP 1 677 220 A2

# FIG. 27

```
┌─────────────────┐
│   READ DATA     │ ─────── A10
└─────────────────┘
         │
         ▼
┌─────────────────┐
│  CHECK ELEMENT  │ ─────── A20
│      DATE       │
└─────────────────┘
         │
         ▼
┌─────────────────┐
│  CHECK CONTACT  │ ─────── A30
│      DATA       │
└─────────────────┘
         │
         ▼
┌─────────────────┐
│  CHECK HISTORY  │ ─────── A40
│      DATA       │
└─────────────────┘
         │
         ▼
┌─────────────────┐
│     CREATE      │ ─────── A50
│  RESULT DATA    │
└─────────────────┘
```

# FIG. 28

```
        ┌─────────┐
        │  START  │
        └─────────┘
             │
             ▼
   ┌──────────────────────┐
   │ ENTER ANALYSIS DATA  │──── B10
   │      FILE NAME       │
   └──────────────────────┘
             │
             ▼
   ┌──────────────────────┐
   │ STORE FILE NAME INTO │──── B20
   │      ARRAY FILE      │
   └──────────────────────┘
             │
             ▼
   ┌──────────────────────┐
   │      READ DATA       │──── B30
   └──────────────────────┘
             │
             ▼
        ╱─────────╲
  YES  ╱  END OF   ╲──── B40
◄─────╱   DATA?     ╲
       ╲           ╱
        ╲─────────╱
             │ NO
             ▼
        ╱─────────╲
       ╱  TYPE OF  ╲──── B50
       ╲ DATA READ?╱
        ╲─────────╱
             │
```

MATERIAL → STORE INTO ARRAY MAT — B60

NODE → STORE INTO ARRAY NODE — B70

ELEMENT GROUP → STORE INTO ARRAY ELEM — B80

CONTACT PAIR → STORE INTO ARRAY CONTACT — B90

CONTACT SURFACE → STORE INTO ARRAY CONSURF — B100

ELEMENT → STORE INTO ARRAY ELEMENT — B110

```
        ┌─────────┐
        │   END   │
        └─────────┘
```

# FIG. 29

START

READ ARRAY ELEM — C10

END OF DATA? — C20

YES

NO

READ ARRAY MAT — C30

COMPARE MATERIAL NUMBERS OF ARRAYS ELEM AND MAT — C40

UNMATCHED

MATCHED

STORE MATERIAL NAME, YOUNG'S MODULUS AND POISSON'S RATIO INTO ARRAY ELEM — C50

END

## FIG. 30

START

LOOP1
I : 1,1,END OF DATA

D10 — READ NODE NUMBER FROM ARRAY CONSURF

D20 — READ NODE COORDINATES FROM ARRAY NODE

D30 — CALCULATE CONTACT SURFACE EQUATION (ax+by+cz+d=0)AND STORE IT INTO ARRAY CONSURF

D40 — STORE CONTACT SURFACE GROUP NUMBER INTO congr

D50 — congr1=congr — YES

NO

D60 — J+1→J

D70 — READ MASTER SURFACE GROUP NUMBER FROM ARRAY CONTACT

D80 — END OF DATA? — YES

NO

D90 — CONSURF(2,I)=CONTACT(4,J) — NO

YES

D100 — 1→FLG congr→congr1

D140 — FLG=1

FLG=0 — D110

D120 — CREATE AND STORE INTO ARRAY CNSURF A SURFACE WHOSE NORMAL DIRECTION IS VERTICAL TO THE NORMAL OF THE CONTACT SURFACE AND FACING INWARD THE SURFACE

D130 — 0→J

LOOP1

END

## FIG. 31

START

LOOP1
I:1,1,END OF DATA

E10 — READ CONTACT PAIR FROM ARRAY CONTACT AND STORE CONTACT GROUP NUMBER,MASTER SURFACE GROUP NUMBER AND SLAVE SURFACE GROUP NUMBER INTO cong,conm AND cons,RESPECTIVELY

E20 — READ ONE SURFACE FROM ARRAY CONSURF AND STORE CONTACT GROUP NUMBER AND CNTACT SURFACE GROUP NUMBER INTO cong1 AND cons1

E30 — cons=cons1AND cong=cong1 — NO

YES

E40 — STORE SUFFIX OF ARRAY CONSURF INTO SID

E50 — READ ONE SURFACE FROM ARRAY CONSURF AND STORE CONTACT GROUP NUMBER AND CONTACT SURFACE GROUP NUMBER INTO cong1 AND conm1

E60 — conm=conm1AND cong=cong1 — NO

YES

E70 — STORE SUFFIX OF ARRAY CONSURF INTO MID

LOOP2
J1:STD,1,END OF SLAVE

LOOP3
K1:1,1,4

LOOP4
L:1,1 END OF DATA

E80 — ARRAY CONNODE MATCHES WITH MASTER SURFACE GROUP NUMBER,SLAVE SURFACE GROUP NUMBER AND NODE NUMBER? — YES

NO

LOOP4

E90 — RETRIEVE NODE COORDINATES FROM ARRAY NODE ACCORDING TO NODE NUMBER OF THE SLAVE SURFACE

E100 — SLAVE SURFACE NODES EXIST WITHIN MASTERSURFACE REGION? — NO

YES

E110 — CALCULATE DISTANCE BETWEEN MASTER SURFACE AND SLAVE NODES,AND CHECK FOR PENETRATION

E120 — STORE MASTER SURFACE NUMBER,NODE NUMBER,DISTANCE,NORMAL OF CONTACT SURFACE,RESULT OF PENETRATION CHECK INTO ARRAYS CONNODE AND CONTACT

E130 — SLAVE NORMALS MATCH? — YES

NO

E140 — STORE MATCHED ARRAY CONNODE NEWLY INTO ARRAY CONNODE

E150 — STORE NORMAL OF SLAVE SURFACE INTO ARRAY CONNODE

LOOP3

LOOP2

LOOP1

END

EP 1 677 220 A2

# FIG. 32

START

F10 — STORE NORMAL ANGLE 370 INTO ARRAY CONNODE

LOOP2

I:1,1 END OF DATA

F20 — READ DATA FROM ARRAY CONNODE

F30 — NORMAL ANGLE=370? — NO

YES

F40 — READ NORMAL AND CALCULATE ANGLE

F50 — STORE NORMAL ANGLE AND ANGLE CHECK RESULT INTO ARRAYS CONNODE AND CONTACT

LOOP3

J:I+1,1 END OF DATA

F60 — NORMALS MATCH? — NO

YES

F70 — STORE NORMAL ANGLE AND NORMAL CHECK RESULT INTO ARRAYS CONTACT AND CONNODE

LOOP3

LOOP2

END

# FIG. 33

```
                    ┌──────────┐
                    │  START   │
                    └────┬─────┘
                         ↓
              ┌──────────────────────┐
              │        LOOP1         │
              │                      │
              │  I:1,1 END OF DATA   │
              └──────────┬───────────┘
                         ↓
G10 ────┐     ┌──────────────────────┐
        │     │   READ EXISTING      │
        │     │        DATA          │
              └──────────┬───────────┘
                         ↓
G20 ────┐     ┌──────────────────────┐
        │     │    READ NEW DATA     │←────────────┐
              └──────────┬───────────┘             │
                         ↓                         │
G30 ────┐         ◇────────────◇      YES          │
        │       ◇   FLAG ≠0?    ◇──────────────→   │
                  ◇────────────◇                   │
                         │ NO                       │
                         ↓                          │
G40 ────┐      ◇─────────────────◇   NO             │
        │    ◇  ID COMPARISON      ◇────────────────┤
             ◇    MATCHED?         ◇                │
               ◇─────────────────◇                  │
                         │ YES                       │
                         ↓                           │
G50 ────┐     ┌──────────────────────┐               │
        │     │       FLAG=1         │               │
              └──────────┬───────────┘               │
                         ↓                            │
G60 ────┐        ◇─────────────◇     YES              │
        │      ◇    DATA         ◇─────────────────┐  │
             ◇ CMPARISON MATCHED? ◇                │  │
               ◇─────────────◇                     │  │
                         │ NO                        │  │
                         ↓                           │  │
G70 ────┐     ┌──────────────────────┐              │  │
        │     │   STORE ID AND       │              │  │
        │     │       DATA           │              │  │
              └──────────┬───────────┘              │  │
                         ↓←───────────────────────────┘
              ┌──────────────────────┐
              │        LOOP1         │
              └──────────┬───────────┘
                         ↓
                    ┌──────────┐
                    │   END    │
                    └──────────┘
```